# EUROPEAN PATENT APPLICATION

(11) **EP 2 806 713 A1**
(43) Date of publication of application: **26.11.2014**
(21) Application number: 13738704.9
(22) Date of filing: 16.01.2013
(51) Int. Cl.: H05B 33/12, G09F 9/30, H01L 27/32, H01L 51/50, H05B 33/10, F21Y 105/00

(54) **ORGANIC ELECTROLUMINESCENT ELEMENT, ORGANIC EL LIGHTING AND ORGANIC EL DISPLAY DEVICE**

(30) Priority: 17.01.2012 JP 2012007131
(71) Applicant: Mitsubishi Chemical Corporation, Chiyoda-ku Tokyo 100-8251 (JP)
(72) Inventor: TSURUTANI Yasuyuki, Yokohama-shi Kanagawa 227-8502 (JP); IMADA Ichiro, Yokohama-shi Kanagawa 227-8502 (JP)
(74) Representative: Hoffmann Eitle
(86) International application number: PCT/JP2013/050682
(87) International publication number: WO 2013/108787

(57) **Abstract**

An object of the present invention is to provide an organic electroluminescent element having a low driving voltage, a high white light luminescence efficiency, and an excellent reproducibility. The organic electroluminescent element of the invention comprises a cathode, an anode, and a light emitting layer between the cathode and the anode, wherein the light emitting layer comprises, in the order from the side of the anode: a layer containing an charge transport material and a phosphorescent-light emitting material of a low-molecular compound, in which the layer is formed by a wet film forming method; and a layer containing an charge transport material and a fluorescent-light emitting material of a low-molecular compound, in which the layer is formed by a vacuum deposition method, wherein the organic electroluminescent element has an emission spectrum having a maximum emission wavelength in a 440 to 500 nm region, a 510 to 550 nm region and a 580 to 630 nm region.

## Description

### Technical Field

The present invention relates to organic electroluminescent elements, and organic EL lighting and organic EL display devices. Specifically, the present invention relates to an organic electroluminescent element having low driving voltage, high white light luminescence efficiency, and excellent reproducibility, and to organic EL lighting and organic EL display devices that use such organic electroluminescent element.

### Background Art

Since the introduction of the laminated organic electroluminescent (hereinafter, also referred to as "EL") element by Kodak using vapor deposition, organic EL displays have been actively developed, and have been put to actual applications.

Such a laminated organic electroluminescent element includes a plurality of organic layers (including a light emitting layer, a hole injection layer, a hole transport layer, and an electron transport layer) as a laminate between the anode and the cathode. The laminated organic electroluminescent element has attracted interest for its wide viewing angle and good visibility offered by the self-emitting characteristic of the element, and for its thinness advantageous for conserving space.

Another notable characteristic of the organic electroluminescent element that distinguishes itself from the conventional light emitting diodes and cold cathode tubes is that the element is surface emitting. This characteristic is exploited in many applications, including backlights and illuminations, and full-color displays using color filters.

For these applications, a white light source is suited, and a white emitting organic electroluminescent element is needed.

In a proposed method for obtaining a white emitting organic electroluminescent element, light emitting materials of red, green, and blue are added to a single layer, as disclosed in, for example, Patent Document 1. If this method were to be used to form a light emitting layer by vacuum vapor deposition, a total of at least four materials (red, green, blue, and host material) need to be simultaneously deposited by vapor deposition.

Patent Documents 2 to 4 disclose methods for laminating a plurality of light emitting layers of different emission wavelengths containing sole light emitting dopants.

Patent Document 5 discloses a method for obtaining white emission whereby any one of red, green, and blue colors is combined with its complementary color.

Patent Document 6 discloses a method for obtaining white emission with the use of two or more light emitting layers, specifically a first light emitting layer formed by a wet film forming method using a polymer material as a charge transport material, and a second light emitting layer formed by a dry deposition method using a low molecular material.

Patent Document 7 describes an organic electroluminescent element that includes two light emitting layers, and that can produce white emission by allowing a plurality of guest materials to simultaneously emit light. One of the two light emitting layers is formed by coating, whereas the other is formed by vacuum vapor deposition. A phosphorescent compound is used as a guest compound in each of the two light emitting layers.

### Citation List

### Patent Documents

Patent Document 1: WO2006-093007
Patent Document 2: JP-A-2003-187977
Patent Document 3: JP-A-2004-63349
Patent Document 4: JP-A-2006-287154
Patent Document 5: JP-A-2001-52870
Patent Document 6: JP-A-2008-159367
Patent Document 7: JP-A-2010-034484

### Summary of the Invention

### Problems that the Invention is to Solve

However, the foregoing techniques of the related art are problematic in the following respects. In Patent Document 1, a total of at least four materials (red, green, blue, and a host material) need to be simultaneously deposited in the vapor deposition, as described above. However, the vacuum deposition method does not allow for simultaneous vapor deposition of more than three materials, and it is very difficult to control the vapor deposition of four or more materials. Reproducibility is poor accordingly.

The methods described in Patent Documents 2 to 4 in which a plurality of light emitting layers of different emission wavelengths containing sole light emitting dopants is laminated are effective in terms of improving color rendering properties. However, chromaticity is susceptible to changes, and, because of the large thickness of the light emitting layers, the driving voltage tends to increase.

In the method described in Patent Document 5 in which one of the red, green, and blue colors is combined with its complementary color, the emission intensity tends to increase in one of the layers when vacuum vapor deposition is used for layer formation, and it is difficult to adjust chromaticity and obtain an effective white emitting organic electroluminescent element.

The method described in Patent Document 6 in which a first light emitting layer is formed by wet deposition using a polymer material and a second light emitting layer is formed by dry deposition using a low molecular material is problematic in the following respects.

Specifically, the polymer material cannot be purified as easily as the low molecular compound, and contains relatively more impurities because of the difficulty in increasing purity. When the polymer compound is used as a light emitting layer material, these impurities trap charges, and causes problems, including increased driving voltage of the organic electroluminescent element, low luminescence efficiency, and short element life.

From the standpoint of improving luminescence efficiency and lowering driving voltage, it is preferable to evenly distribute the emission unit and the charge transport unit in the light emitting layer. However, an even distribution of these two units in the polymer compound molecules requires a special polymerization technique, such as alternate copolymerization, and block copolymerization, and puts a burden on production processes.

A light emitting layer containing a polymeric charge transport material and a low-molecular light emitting material is known. However, it is also very difficult to control and confine the interval of the charge transport units linked by polymer chains in the polymeric charge transport material within a distance that makes it easier to transport charges or move excitons.

In the organic electroluminescent element described in Patent Document 7 in which a plurality of guest materials are caused to simultaneously emit light to obtain white emission with two light emitting layers, problems are caused when the light emitting layers contain a phosphorescent compound as light emitting layer material, and when one of the light emitting layers is formed by coating, and the other is formed by vacuum vapor deposition.

Specifically, when a phosphorescent compound is used as the subject of vacuum vapor deposition in forming the light emitting layers, there is a risk of the phosphorescent-light emitting material molecules of large heat energy colliding with the previously formed underlayer and damaging the underlayer surface. The damaged flat surface (interface) promotes aggregation of the materials contained in the layer, and the aggregates cause charge trapping, as will be described later in detail.

It is an object of the present invention to solve the foregoing problems, and provide an organic electroluminescent element having low driving voltage, high white light luminescence efficiency, and excellent reproducibility.

### Means for Solving the Problems

The present inventors conducted intensive studies to solve the foregoing problems, and found that the problems could be solved by using a low molecular compound as both the charge transport material and the light emitting material of the light emitting layer, and by using these materials in a specific element configuration. The present invention was completed on the basis of this finding, follows.

Specifically, the gist of the present invention includes the following (1) to (6).
(1) An organic electroluminescent element comprising an anode, a cathode, and a light emitting layer formed between the anode and the cathode,
   wherein the light emitting layer comprises two or more layers, each of which contains a different light emitting material,
   the light emitting layer includes a layer formed by a wet film forming method (hereinafter, also referred to as "coated light emitting layer" or "first light emitting layer"), and a layer formed by a vacuum deposition method (hereinafter, also referred to as "vapor deposited light emitting layer" or "second light emitting layer"), in this order from the anode side,
   the layer formed by a wet film forming method is a layer containing a phosphorescent-light emitting material and a charge transport material, both of which are a low molecular compound,
   the layer formed by a vacuum deposition method is a layer containing a fluorescent-light emitting material and a charge transport material, both of which are a low molecular compound, and
   the organic electroluminescent element has an emission spectrum having a maximum emission wavelength in a 440 to 500 nm region, a 510 to 550 nm region, and a 580 to 630 nm region.
(2) The organic electroluminescent element according to the item (1) above, wherein the layer formed by a wet film forming method is a layer having a maximum emission wavelength in at least two regions of the 440 to 500 nm region, the 510 to 550 nm region, and the 580 to 630 nm region.
(3) The organic electroluminescent element according to the item (1) or (2) above, further comprising a hole transport layer between the anode and the light emitting layer.
(4) The organic electroluminescent element according to the item (3) above, wherein the hole transport layer is a layer formed by a wet film forming method.
(5) An organic EL lighting comprising the organic electroluminescent element according to any one of the items (1) to (4) above.
(6) An organic EL display device comprising the organic electroluminescent element according to any one of the items (1) to (4) above.

### Advantage of the Invention

The present invention provides a white emitting organic electroluminescent element having low driving voltage, high luminescence efficiency, and desirable reproducibility.

The organic electroluminescent element of the present invention has potential application in areas where the surface emitting characteristic can be exploited, including, for example, white light sources (for example, the light source of copiers, the backlight light source of liquid crystal displays and instruments, and color filter display devices), display boards, and marker lights. The organic electroluminescent element thus has high technical values.

### Brief Description of the Drawings

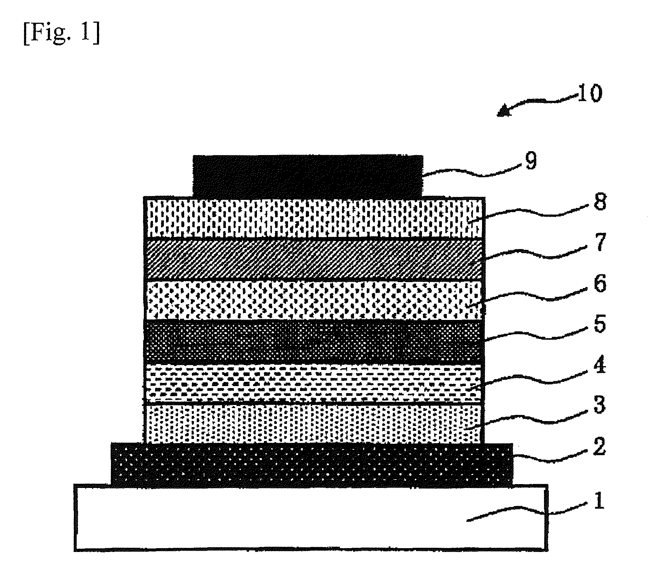

FIG. 1 is a cross sectional view schematically representing an exemplary structure of an organic electroluminescent element of the present invention.

### Mode for Carrying Out the Invention

Embodiments of the organic electroluminescent element and the organic EL lighting and organic EL display device of the present invention are described below in detail. It should be noted that the descriptions of the constituent elements below are intended solely to illustrate the examples (representative examples) of the embodiments of the present invention, and the present invention should not be construed as being specifically limited to the contents of the following descriptions, as long as the contents of the invention do not depart from the gist of the present invention.

### Organic Electroluminescent Element

The organic electroluminescent element of the present invention includes an anode, a cathode, and a light emitting layer formed between the anode and the cathode. The light emitting layer is formed of two or more layers containing different light emitting materials. The light emitting layer includes a layer (coated light emitting layer) formed by a wet film forming method, and a layer (vapor deposited light emitting layer) formed by a vacuum deposition method, in this order from the anode side. The coated light emitting layer is a layer containing a phosphorescent-light emitting material and a charge transport material both of which are low molecular compounds. The vapor deposited light emitting layer is a layer containing a fluorescent-light emitting material and a charge transport material both of which are low molecular compounds. The organic electroluminescent element has an emission spectrum having a maximum emission wavelength in a 440 to 500 nm region, a 510 to 550 nm region, and a 580 to 630 nm region.

Specifically, in the organic electroluminescent element of the present invention, the coated light emitting layer contains a low-molecular-weight charge transport material and a low-molecular-weight phosphorescent-light emitting material, and the vapor deposited light emitting layer contains a low-molecular-weight charge transport material and a low-molecular-weight fluorescent-light emitting material.

In the present invention, low molecular compounds are used for the light emitting material and the charge transport material for the following reason.

As described above, in the light emitting layer that contains a polymeric charge transport material and a low-molecular light emitting material, it is very difficult to control and confine the interval of the charge transport units linked by polymer chains in the polymeric charge transport material within a distance that makes it easier to transport charges or move excitons.

The wet deposition and the vacuum vapor deposition using the low-molecular-weight charge transport material produce high film density than the wet deposition using the high molecular weight charge transport material, and improve the intermolecular adhesion at the coating/vapor deposition interface. This is preferable as it makes it easier to give and receive charges, and lower the voltage.

For this reason, low molecular compounds are used for all the light emitting layer materials used in the organic electroluminescent element of the present invention.

The organic electroluminescent element of the present invention preferably further includes a hole transport layer between the anode and the light emitting layer, because it allows the holes to be sufficiently injected from the anode into the light emitting layer closest to the cathode.

### Low Molecular Compound

The light emitting layer of the organic electroluminescent element of the present invention contains a light emitting material and a charge transport material both of which are low molecular compounds.

The molecular weight of the "low molecular compound" as used herein is typically 10,000 or less, preferably 5,000 or less, more preferably 4,000 or less, further preferably 3,000 or less, and typically 100 or more, preferably 200 or more, more preferably 300 or more, further preferably 400 or more.

An excessively small molecular weight of the light emitting material may cause various problems, including considerably low heat resistance, gas generation, formation of a low-quality film, and morphology changes in the organic electroluminescent element due to migration. On the other hand, an excessively large molecular weight of the light emitting material may make it difficult to purify the organic compounds, or increase the time required to dissolve in solvent.

Confining the molecular weight of the light emitting material in the foregoing ranges is advantageous, because it provides a high glass transition temperature, a high melting point, and a high degradation temperature, and desirable heat resistance for the light emitting layer material and the resulting light emitting layer. Other advantages are that lowering of film quality due to recrystallization or molecule migration, and increased impurity concentration associated with the material pyrolysis are unlikely to occur. The unlikelihood of element performance drop, and ease of purification are also advantages.

When the light emitting layer of the organic electroluminescent element of the present invention includes a compound other than the light emitting material and the charge transport material, the compound is preferably a low molecular compound with a molecular weight of preferably 10,000 or less, more preferably 5,000 or less, further preferably 4,000 or less, particularly preferably 3,000 or less, and preferably 100 or more, more preferably 200 or more, further preferably 300 or more, particularly preferably 400 or more.

### Maximum Emission Wavelength of Emission Spectrum

The organic electroluminescent element of the present invention has an emission spectrum having a maximum emission wavelength in a 440 to 500 nm region, a 510 to 550 nm region, and a 580 to 630 nm region.

The organic electroluminescent element of the present invention with such an emission spectrum may be obtained, for example, by appropriately selecting and using a light emitting material for the light emitting layer so that the emission spectrum of the organic electroluminescent element has a maximum emission wavelength in a 440 to 500 nm region, a 510 to 550 nm region, and a 580 to 630 nm region.

The organic electroluminescent element of the present invention may be designed with a color filter, a polarizing plate, a retardation plate, a diffusion plate, a fluorescence conversion film, or the like to have a maximum emission wavelength in each region. However, it is preferable in the organic electroluminescent element of the present invention to appropriately select and use a light emitting material for the light emitting layer so that the emission spectrum of the organic electroluminescent element has a maximum emission wavelength in a 440 to 500 nm region, a 510 to 550 nm region, and a 580 to 630 nm region.

### Emission Spectrum Measurement Method

The emission spectrum of the organic electroluminescent element of the present invention may be measured by using, for example, a spectroscope USB4000 (Ocean Optics).

The emission spectrum measurement device is not limited to the device exemplified above, and other measurement devices may be used, provided that the devices are equivalent in terms of measurement capability. It is, however, preferable to use the foregoing measurement device.

### Light Emitting Layer

The light emitting layer of the present invention is a layer that serves as the main light source upon being excited by the recombination of the holes and the electrons injected from the anode and the cathode, respectively, under an applied electric field across the electrodes. As described above, the light emitting layer includes a coated light emitting layer containing a phosphorescent-light emitting material and a charge transport material both of which are low molecular compounds, and a vapor deposited light emitting layer containing a fluorescent-light emitting material and a charge transport material both of which are low molecular compounds, in this order from the anode side.

With the coated light emitting layer and the vapor deposited light emitting layer contained in the light emitting layer from the anode side, the light emitting layer can be obtained as a film of uniform quality. Further, high efficiency can be obtained with the phosphorescent-light emitting material contained in the coated light emitting layer, and sufficient emission intensity can be obtained with the fluorescent-light emitting material contained in the vapor deposited light emitting layer. Further, the luminescence efficiency of the organic electroluminescent element can improve by the following mechanism of action with the fluorescent-light emitting material-containing vapor deposited light emitting layer laminated on the phosphorescent-light emitting material-containing coated light emitting layer.

First, a composition containing a phosphorescent-light emitting material and a charge transport material is deposited by wet deposition as the first light emitting layer (coated light emitting layer). The phosphorescent-light emitting material is typically a complex that contains metal atoms of large atomic weights such as Ir and Pt. Because the compound containing metal atoms of large atomic weights has lower surface energy and is chemically more stable outside of the outermost surface of the film, it is believed that the phosphorescent-light emitting material hardly exists on the outermost surface in the presence of a solvent, and that the charge transport material exists in abundance in the extremely thin region on the outermost surface of the dried film.

The region with the abundant charge transport material is believed to block the transfer of energy from the fluorescent-light emitting material of the overlying second light emitting layer to the phosphorescent-light emitting material of the first light emitting layer. This is believed to cause sufficient emission in both the first and second light emitting layers, and provide the organic electroluminescent element of high luminescence efficiency.

In the organic electroluminescent element of the present invention, fluorescent-light emitting material is used as the light emitting material of the second light emitting layer (vapor deposited light emitting layer), because use of phosphorescent-light emitting material as the light emitting material of the vapor deposited light emitting layer has the possibility of causing the following problems.

Specifically, as described above, the phosphorescent-light emitting material is a large-molecular-weight molecule containing metal atoms of large atomic weights, and accordingly the air-borne molecules occurring in the vacuum vapor deposition has large heat energy. If the phosphorescent-light emitting material is used as the light emitting material of the second light emitting layer formed on the first light emitting layer by the vacuum vapor deposition, the phosphorescent-light emitting material molecules of large heat energy would collide with the first light emitting layer and damage the larger surface. The damaged flat surface (interface) promotes aggregation of the materials contained in the layer, and the aggregates cause charge trapping.

Further, because the characteristic barrier function of the element of the present invention by the charge transport material on the first light emitting layer surface is lost by the air-borne phosphorescent-light emitting material molecules occurring in the vapor deposition, there is a risk of the triplet energy in the first light emitting layer being transferred to the second light emitting layer, causing insufficient emission in the first light emitting layer, and possibly disrupting the color balance in the emitted light.

### Light Emitting Material

### Fluorescent-light emitting material

The fluorescent-light emitting material used as light emitting material in the vapor deposited light emitting layer is described below.

### (1) 440 to 500 nm region (blue)

The fluorescent-light emitting material (blue fluorescent dye) for providing blue emission with the maximum emission wavelength in 440 to 500 nm region may be, for example, naphthalene, chrysene, perylene, pyrene, anthracene, coumalin, p-bis(2-phenylethenyl)benzene, arylamine, or a derivative thereof, of which anthracene, chrysene, pyrene, arylamine, and derivatives thereof are preferred.

Styrylamine compounds, and arylamine compounds are particularly preferred because of high blue color purity, high efficiency, and longevity.

For efficient trapping of the holes in the light emitting layer, styrylamine compounds represented by the following formula (A) are preferable. 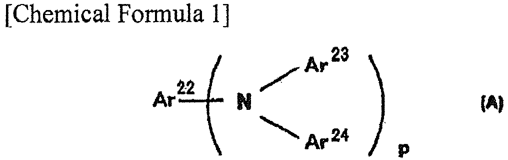 (In the formula (A), Ar²² is a group selected from biphenyl, terphenyl, stilbene, and distyrylaryl, Ar²³ and Ar²⁴ are each independently a hydrogen atom, or an aromatic group of 6 to 20 carbon atoms, and Ar²², Ar²³, and Ar²⁴ may have a substituent. p is an integer of 1 to 4. Preferably, at least one of Ar²³ and Ar²⁴ is substituted with styryl.)

Examples of the aromatic group of 6 to 20 carbon atoms include aromatic hydrocarbon groups such as phenyl, naphthyl, anthranil, phenanthryl, and terphenyl.

For efficient trapping of the holes in the light emitting layer, arylamine compounds represented by the following formula (B) are preferable. 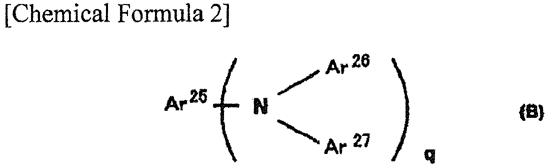 (In the formula (B), Ar²⁵ is substituted or unsubstituted aryl of 10 to 40 nuclear carbon atoms, Ar²⁶ and Ar²⁷ are each independently substituted or unsubstituted aryl of 5 to 40 nuclear carbon atoms. q is an integer of 1 to 4.)

Examples of the aryl of 10 to 40 nuclear carbon atoms represented by Ar²⁵ include naphthyl, anthranil, phenanthryl, pyrenyl, chrysenyl, coronyl, biphenyl, terphenyl, diphenylanthranil, carbazolyl, benzoquinolyl, fluoranthenyl, acenaphthofluoranthenyl, and stilbene.

Examples of the aryl of 5 to 40 nuclear carbon atoms represented by Ar²⁶ and Ar²⁷ include phenyl, naphthyl, anthranil, phenanthryl, pyrenyl, chrysenyl, coronyl, biphenyl, terphenyl, pyrrolyl, furanyl, thiophenyl, benzothiophenyl, oxadiazolyl, diphenylanthranil, indolyl, carbazolyl, pyridyl, benzoquinolyl, fluoranthenyl, acenaphthofluoranthenyl, and stilbene.

When the aryl has a substituent, preferred examples of the substituent include alkyl of 1 to 6 carbon atoms (such as ethyl, methyl, i-propyl, n-propyl, s-butyl, t-butyl, pentyl, hexyl, cyclopentyl, and cyclohexyl), alkoxy of 1 to 6 carbon atoms (such as ethoxy, methoxy, i-propoxy, n-propoxy, s-butoxy, t-butoxy, pentoxy, hexyloxy, cyclopentoxy, and cyclohexyloxy), aryl of 5 to 40 nuclear atoms, amino groups substituted with aryl of 5 to 40 nuclear atoms, ester groups having aryl of 5 to 40 nuclear atoms, ester groups having alkyl of 1 to 6 carbon atoms, cyano, nitro, and halogen atoms.

The following presents specific preferred examples of the blue emission-producing fluorescent-light emitting materials used in the present invention. The present invention, however, is not limited to these.

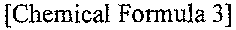

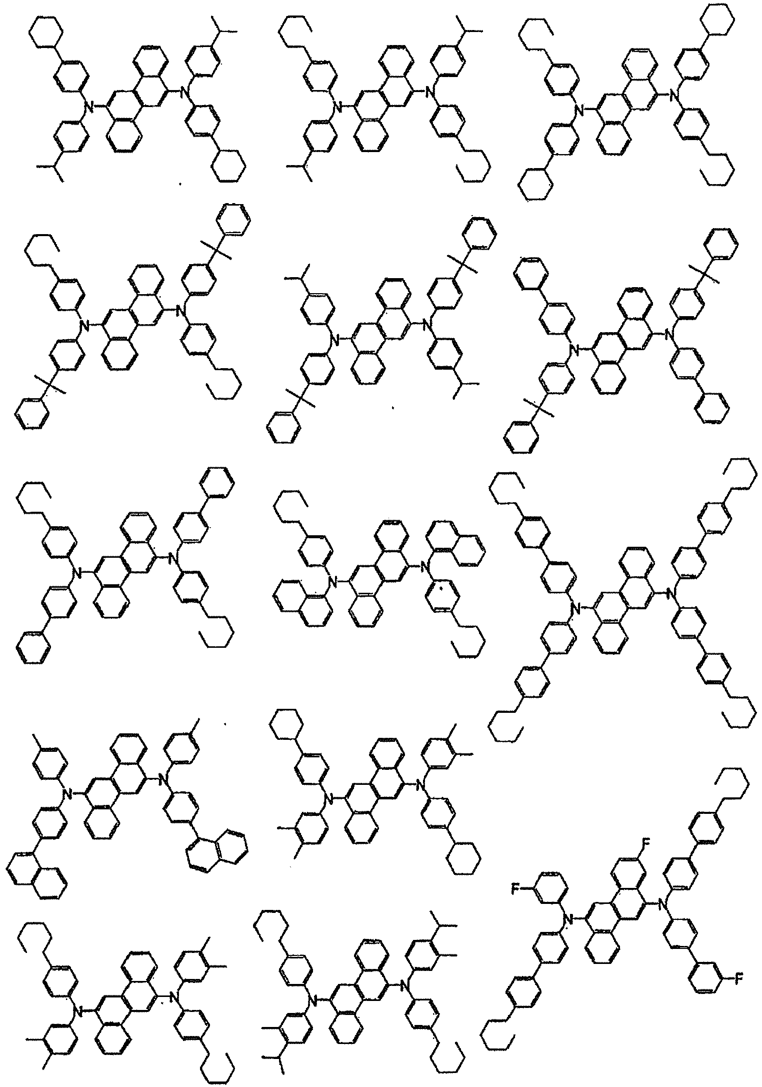

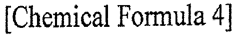

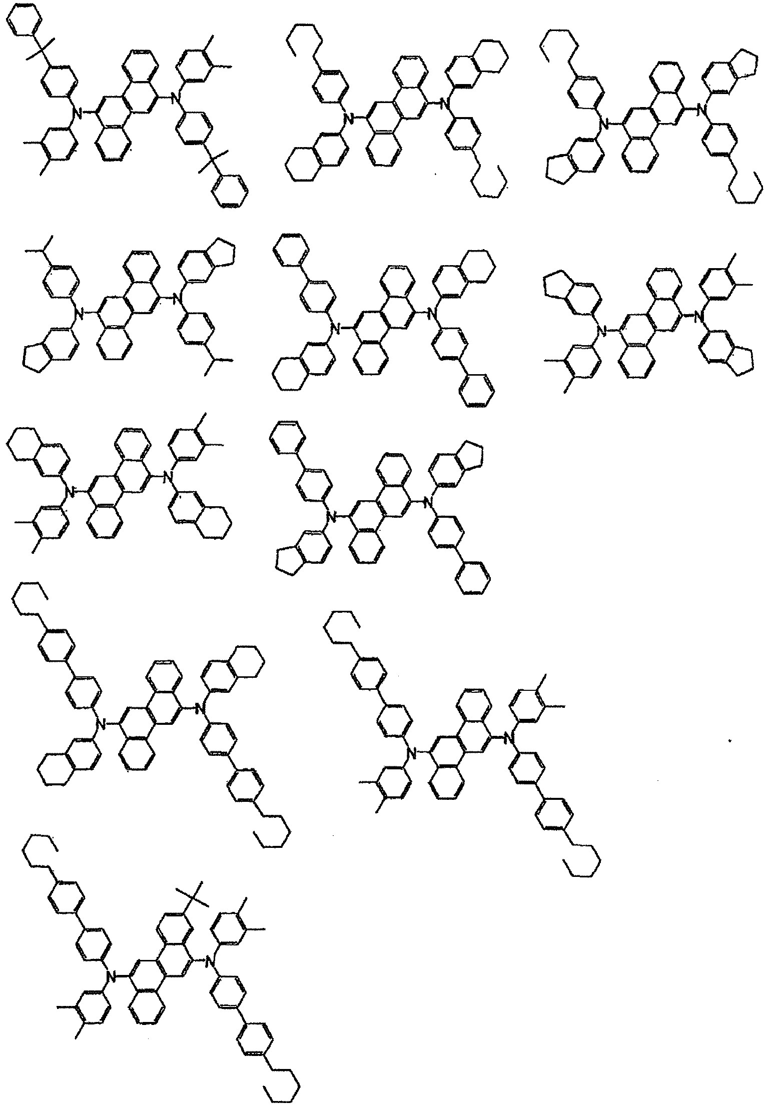

The blue emission-producing fluorescent-light emitting materials may be use either alone, or in any combination and proportion of two or more.

### (2) 510 to 550 nm region (green)

The fluorescent-light emitting material (green fluorescent dye) for providing green emission with the maximum emission wavelength in 510 to 550 nm region may be, for example, quinacridone, coumalin, an aluminum complex such as Al(C₉H₆NO)₃, or a derivative thereof. These may be used either alone, or in any combination and proportion of two or more.

### (3) 580 to 630 nm region (red)

The fluorescent-light emitting material (red fluorescent dye) for providing red emission with the maximum emission wavelength in 580 to 630 nm region may be, for example, a DCM(4-(dicyanomethylene)-2-methyl-6-(p-dimethylaminostyrene)-4H-pyran) compound, benzopyran, rhodamine, xanthene such as benzothioxanthene and azabenzothioxanthene, or a derivative thereof. These may be used either alone, or in any combination and proportion of two or more.

### Phosphorescent-light emitting material

The phosphorescent-light emitting material used as light emitting material in the coated light emitting layer is described below.

Examples of the phosphorescent-light emitting material include Werner-type complexes or organic metal complexes that contain a center metal selected from Group 7 to 11 of the long form periodic table (in the following, "periodic table" refers to the long form periodic table, unless otherwise stated).

Preferred examples of the metals selected from Group 7 to 11 of the periodic table include ruthenium (Ru), rhodium (Rh), palladium (Pd), silver (Ag), rhenium (Re), osmium (Os), iridium (Ir), platinum (Pt), and gold (Au), more preferably iridium and platinum.

The complex ligand is preferably a ligand in which (hetero)aryl such as a (hetero)arylpyridine ligand, and a (hetero)arylpyrazole ligand is joined to compounds such as pyridine, pyrazole, and phenanthroline, particularly preferably a phenylpyridine ligand, and a phenylpyrazole ligand. Here, (hetero)aryl means aryl or heteroaryl.

Specific examples of the phosphorescent-light emitting material include tris(2-phenylpyridine)iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, octaethyl platinum porphyrin, octaphenyl platinum porphyrin, octaethyl palladium porphyrin, and octaphenyl palladium porphyrin.

Particularly preferred as the phosphorescent organic metal complex of the phosphorescent-light emitting material are compounds represented by the following formula (III) or (IV).

ML_{(q-j)}L'ⱼ (III)

(In the formula (III), M represents a metal, and q represents the valency of the metal. L and L' represent bidentate ligands. j represents the number 0, 1, or 2.) 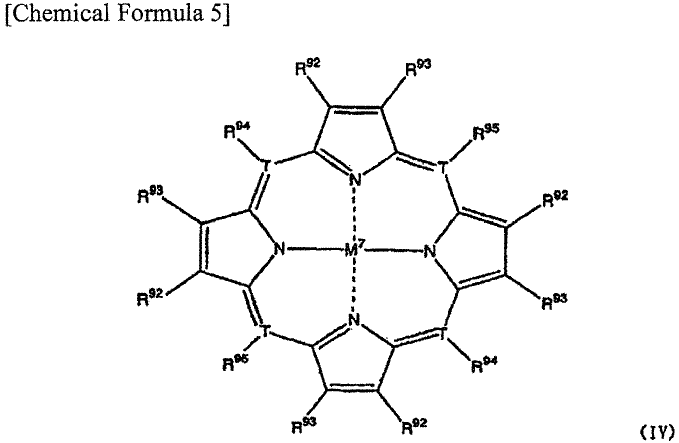 (In the formula (IV), M⁷ represents a metal, and T represents a carbon atom or a nitrogen atom. R⁹² to R⁹⁵ each independently represent a substituent. When T is a nitrogen atom, R⁹⁴ and R⁹⁵ do not exist.)

Compounds represented by formula (III) are described below.

In the formula (III), M represents any metal, preferably the metals specifically exemplified above as metals selected from Group 7 to 11 of the periodic table.

In the formula (III), the bidentate ligand L represents a ligand having the following partial structure.

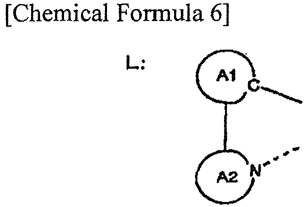

In the partial structure of L, ring A1 represents an aromatic hydrocarbon group or aromatic heterocyclic group that may have a substituent.

Examples of the aromatic hydrocarbon group include groups derived from a single ring or 2 to 5 fused rings of five- or six-membered rings.

Specific examples include monovalent groups derived from a benzene ring, a naphthalene ring, an anthracene ring, a phenanthrene ring, a perylene ring, a tetracene ring, a pyrene ring, a benzopyrene ring, a chrysene ring, a triphenylene ring, an acenaphthene ring, a fluoranthene ring, and a fluorene ring.

Examples of the aromatic heterocyclic group include groups derived from a single ring or 2 to 4 fused rings of five- or six-membered rings.

Specific examples include monovalent groups derived from a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a shinorine ring, a quinoxaline ring, a phenanthridine ring, a benzoimidazole ring, a perimidine ring, a quinazoline ring, a quinazolinone ring, and an azulene ring.

In the partial structure of L, ring A2 represents a nitrogen-containing aromatic heterocyclic group that may have a substituent.

Examples of the nitrogen-containing aromatic heterocyclic group include groups derived from a single ring or 2 to 4 fused rings of five- or six-membered rings.

Specific examples include monovalent groups derived from a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a furopyrrole ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a quinoxaline ring, a phenanthridine ring, a benzoimidazole ring, a perimidine ring, a quinazoline ring, and a quinazolinone ring.

Examples of the substituent of the ring A1 or ring A2 include halogen atoms, alkyl, alkenyl, alkoxycarbonyl, alkoxy, aryloxy, dialkylamino, diarylamino, carbazolyl, acyl, haloalkyl, cyano, and aromatic hydrocarbon groups.

In the formula (III), the bidentate ligand L' represents a ligand having the following partial structures. In the formula, "Ph" represents phenyl.

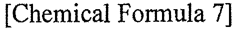

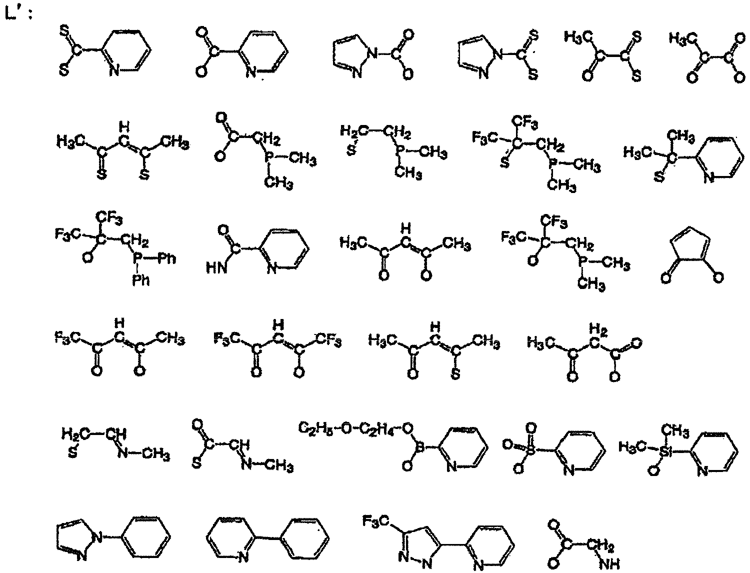

From the viewpoint of complex stability, preferred as L' are the following ligands.

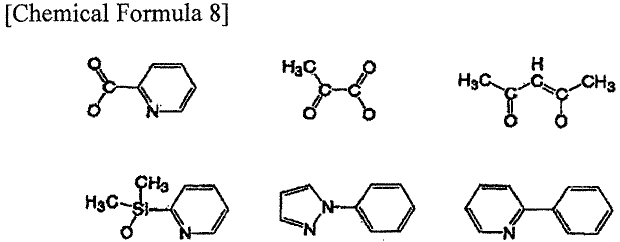

The compounds represented by formula (III) are further preferably compounds represented by the following formulae (IIIa), (IIIb), and (IIIc). 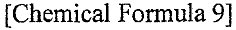 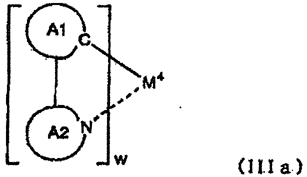 (In the formula (IIIa), M⁴ represents the same metal represented by M, w represents the valency of the metal, ring A1 represents an aromatic hydrocarbon group that may have a substituent, and ring A2 represents a nitrogen-containing aromatic heterocyclic group that may have a substituent.) 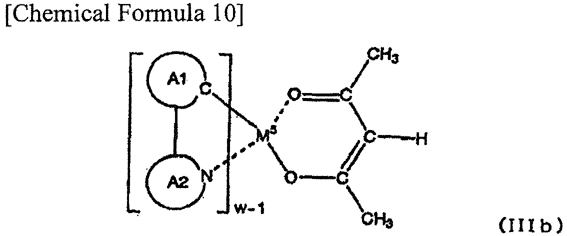 (In the formula (IIIb), M⁵ represents the same metal represented by M, w represents the valency of the metal, ring A1 represents an aromatic hydrocarbon group or aromatic heterocyclic group that may have a substituent, and ring A2 represents a nitrogen-containing aromatic heterocyclic group that may have a substituent.) 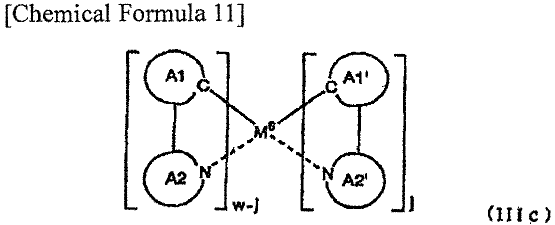 (In the formula (IIIc), M⁶ represents the same metal represented by M, w represents the valency of the metal, j represents 0, 1, or 2, ring A1 and ring A1' each independently represent an aromatic hydrocarbon group or aromatic heterocyclic group that may have a substituent, and ring A2 and ring A2' each independently represent a nitrogen-containing aromatic heterocyclic group that may have a substituent.)

In the formulae (IIIa) to (IIIc), preferred examples of the ring A1 and ring A1' include phenyl, biphenyl, naphthyl, anthryl, thienyl, furyl, benzothienyl, benzofuryl, pyridyl, quinolyl, isoquinolyl, and carbazolyl.

In the formulae (IIIa) to (IIIc), preferred examples of the ring A2 and ring A2' include pyridyl, pyrimidyl, pyradyl, triazyl, benzothiazole, benzooxazole, benzoimidazole, quinolyl, isoquinolyl, quinoxalyl, and phenanthridyl.

Examples of the substituent of the compounds represented by the formulae (IIIa) to (IIIc) include halogen atoms, alkyl, alkenyl, alkoxycarbonyl, alkoxy, aryloxy, dialkylamino, diarylamino, carbazolyl, acyl, haloalkyl, and cyano.

These substituents may be joined to each other to form a ring. As a specific example, the substituent of ring A1 may be bound to the substituent of ring A2, or the substituent of ring A1' and the substituent of ring A2' may be bound to each other to form a single fused ring. An example of such a fused ring is 7,8-benzoquinoline.

More preferred examples of the substituents of rings A1 and A1' and rings A2 and A2' include alkyl, alkoxy, aromatic hydrocarbon groups, cyano, halogen atoms, haloalkyl, diarylamino, and carbazolyl.

Preferred examples of M⁴ to M⁶ in the formulae (IIIa) to (IIIc) include ruthenium, rhodium, palladium, silver, rhenium, osmium, iridium, platinum, and gold.

Particularly preferred as the organic metal complex represented by the formula (III) is a compound in which at least one of the ligands L and L' is a 2-arylpyridine ligand, specifically 2-arylpyridine, with or without a substituent attached thereto, or a group fused thereto.

The compounds described in WO2005/019373 also may be used as the light emitting material.

The compounds represented by formula (IV) are described below.

In the formula (IV), M⁷ represents a metal. Specific examples include the metals exemplified above as metals selected from Groups 7 to 11 of the periodic table. Preferred examples include ruthenium, rhodium, palladium, silver, rhenium, osmium, iridium, platinum, and gold, particularly preferably bivalent metals such as platinum and palladium.

In the formula (IV), R⁹² and R⁹³ each independently represent a hydrogen atom, a halogen atom, alkyl, aralkyl, alkenyl, cyano, amino, acyl, alkoxycarbonyl, carboxyl, alkoxy, alkylamino, aralkylamino, haloalkyl, hydroxyl, aryloxy, an aromatic hydrocarbon group, or an aromatic heterocyclic group.

When T is a carbon atom, R⁹⁴ and R⁹⁵ each independently represent the same substituent exemplified for R⁹² and R⁹³. R⁹⁴ and R⁹⁵ do not exist when T is a nitrogen atom.

R⁹² to R⁹⁵ may be further substituted. When substituted, the substituent is not particularly limited, and may be any group.

Any two of R⁹² to R⁹⁵ may be joined to each other to form a ring.

The following presents specific examples of the phosphorescent-light emitting materials having absorption maximum wavelengths in different wavelength regions. The phosphorescent-light emitting materials below may be used either alone, or in any combination and proportion of two or more. In the formulae below, "Ph" represents phenyl.

### (1) Specific examples of phosphorescent-light emitting material (blue) having an absorption maximum wavelength in a 440 nm to 500 nm region

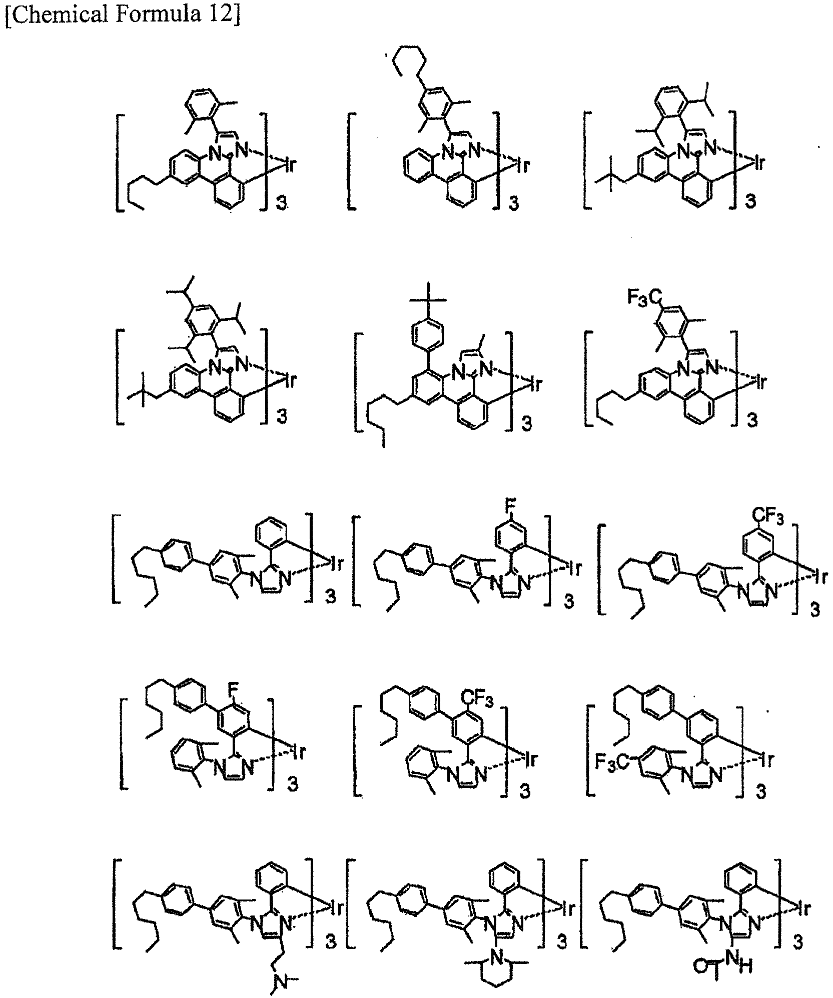

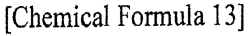

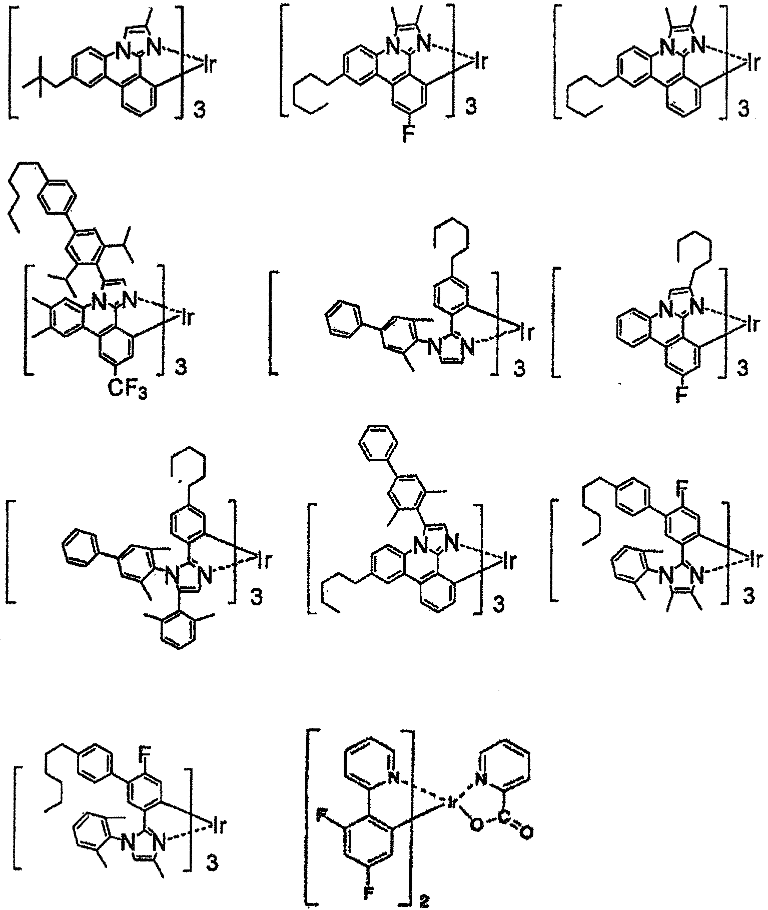

### (2) Specific examples of phosphorescent-light emitting material (green) having an absorption maximum wavelength in a 510 to 550 nm region

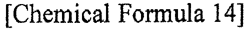

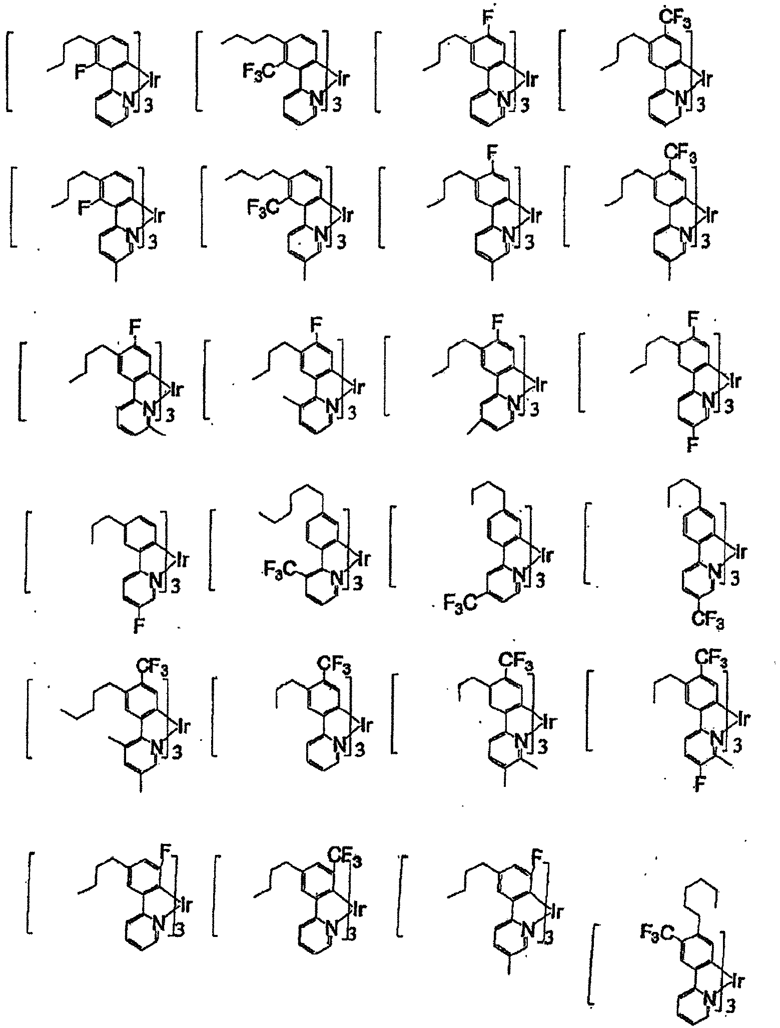

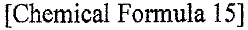

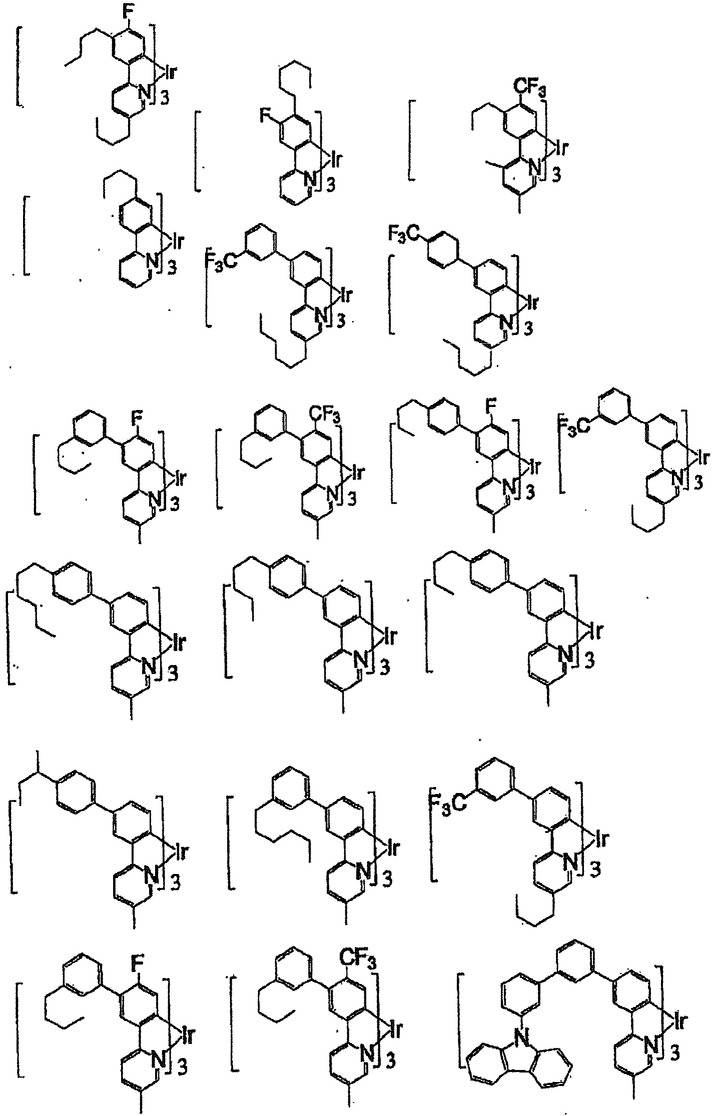

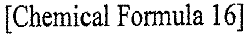

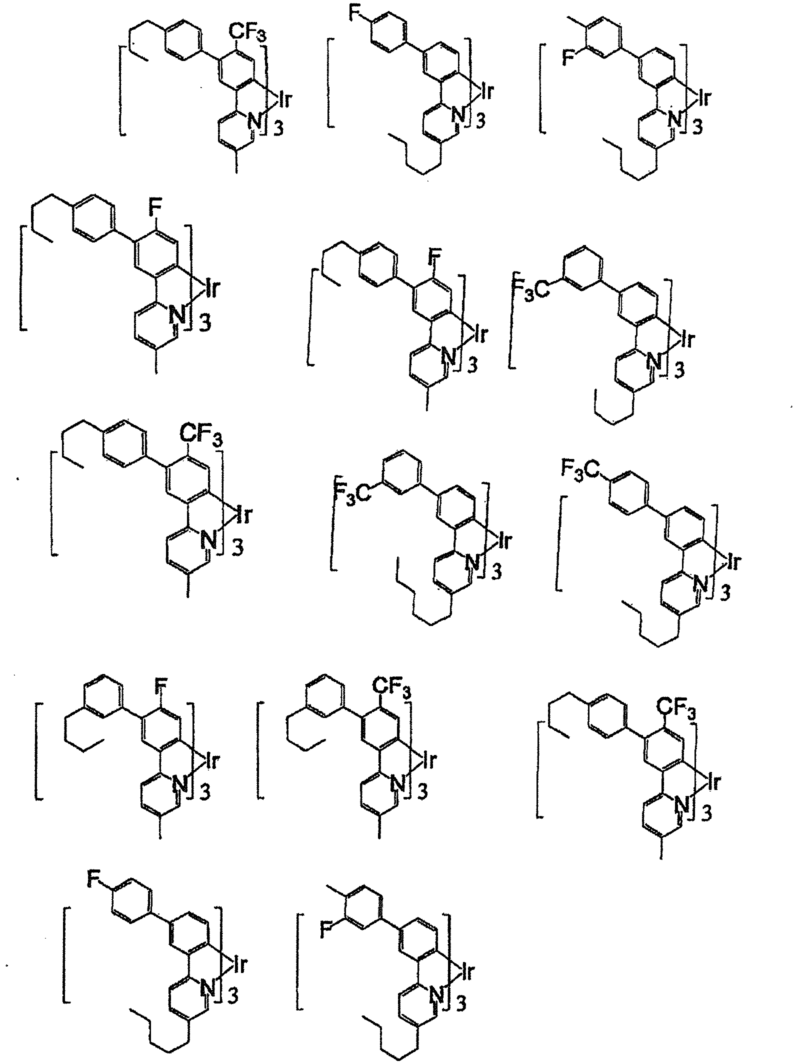

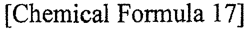

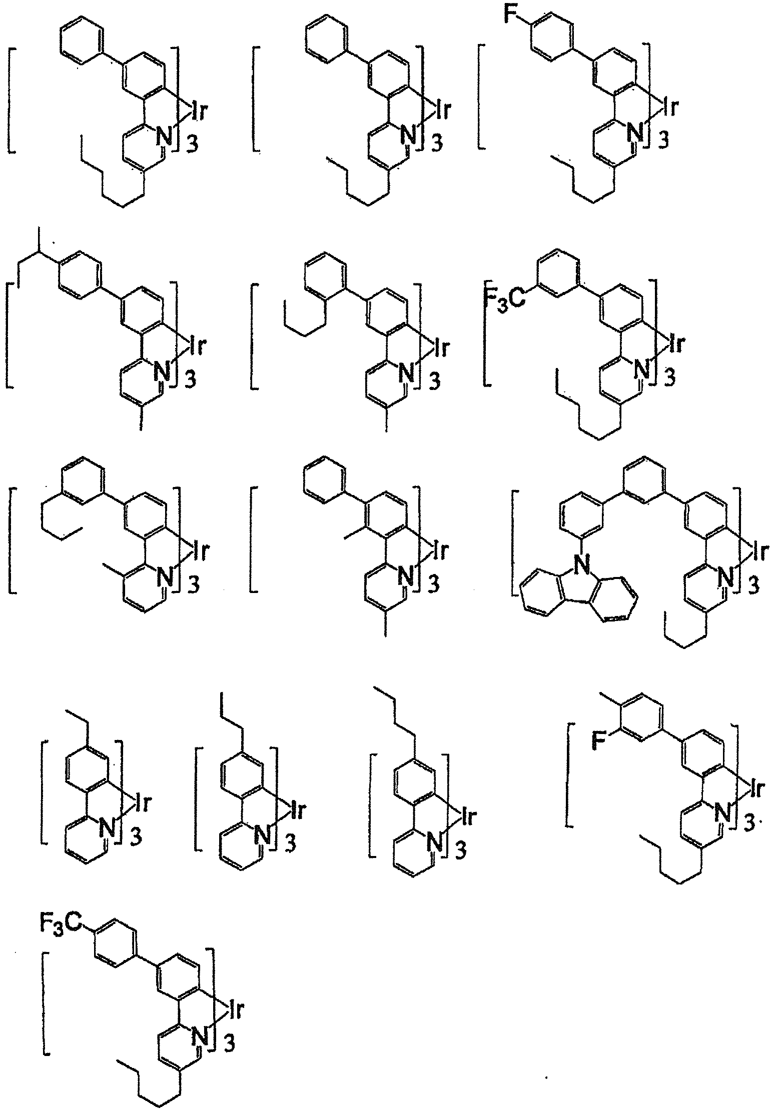

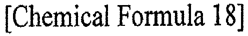

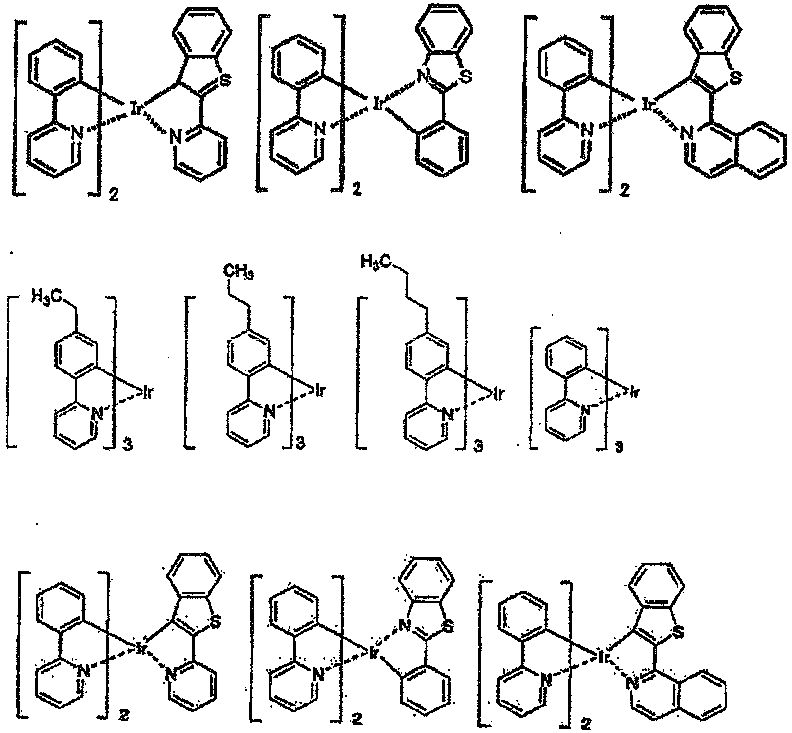

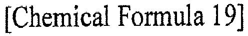

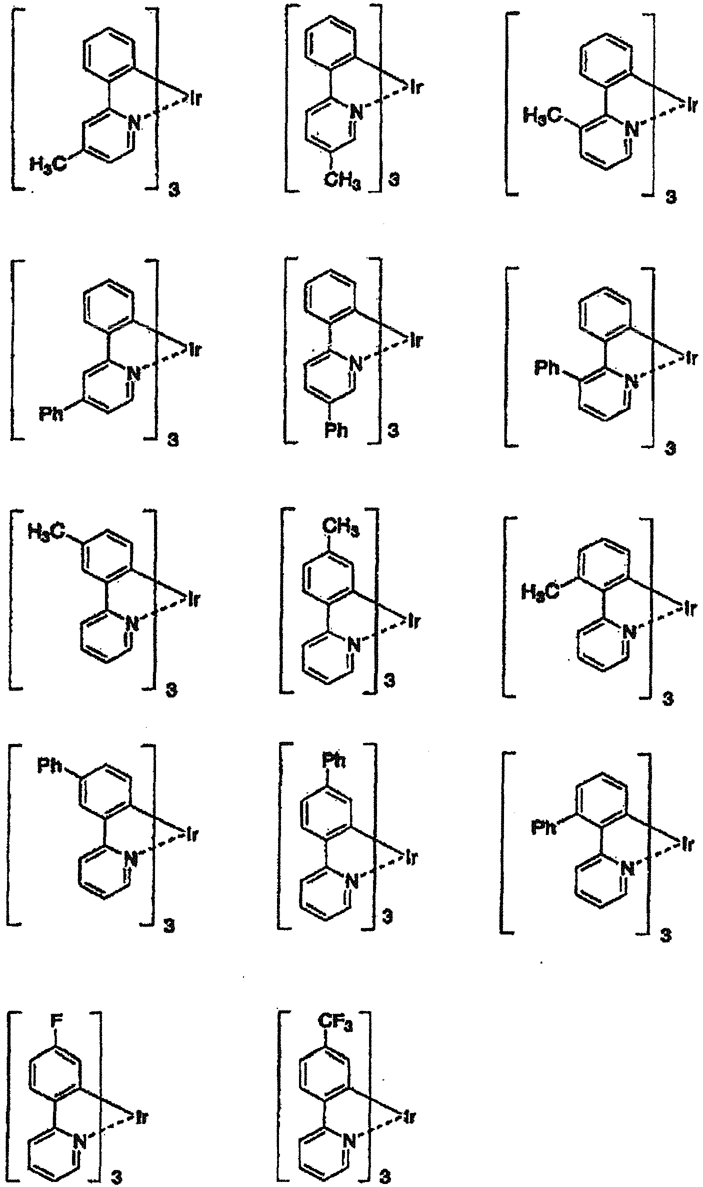

### (3) Specific examples of phosphorescent-light emitting material (red) having an absorption maximum wavelength in a 580 to 630 nm region

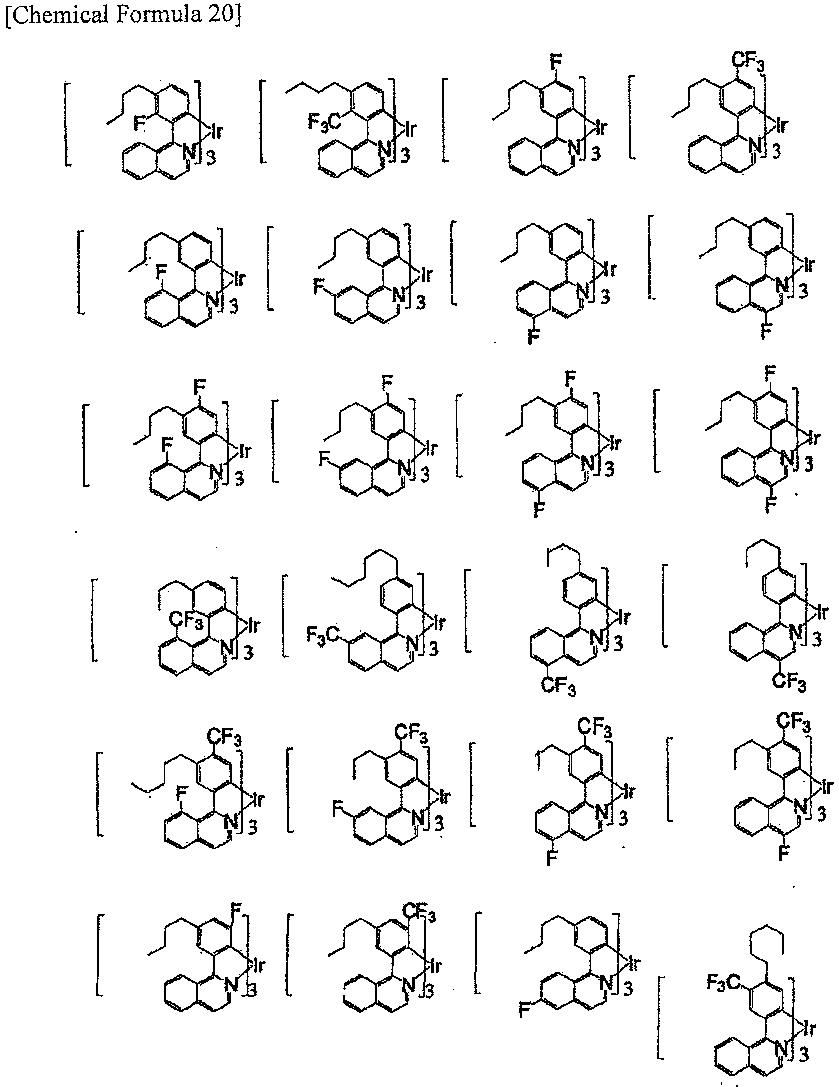

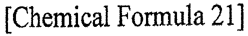

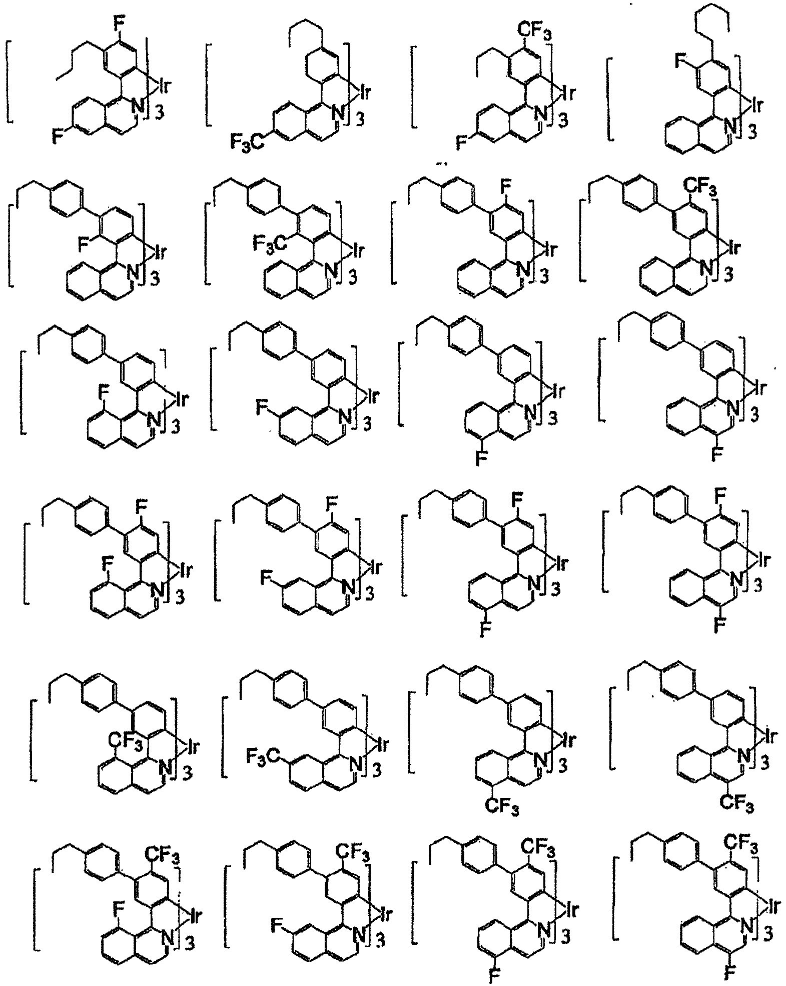

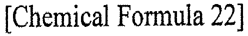

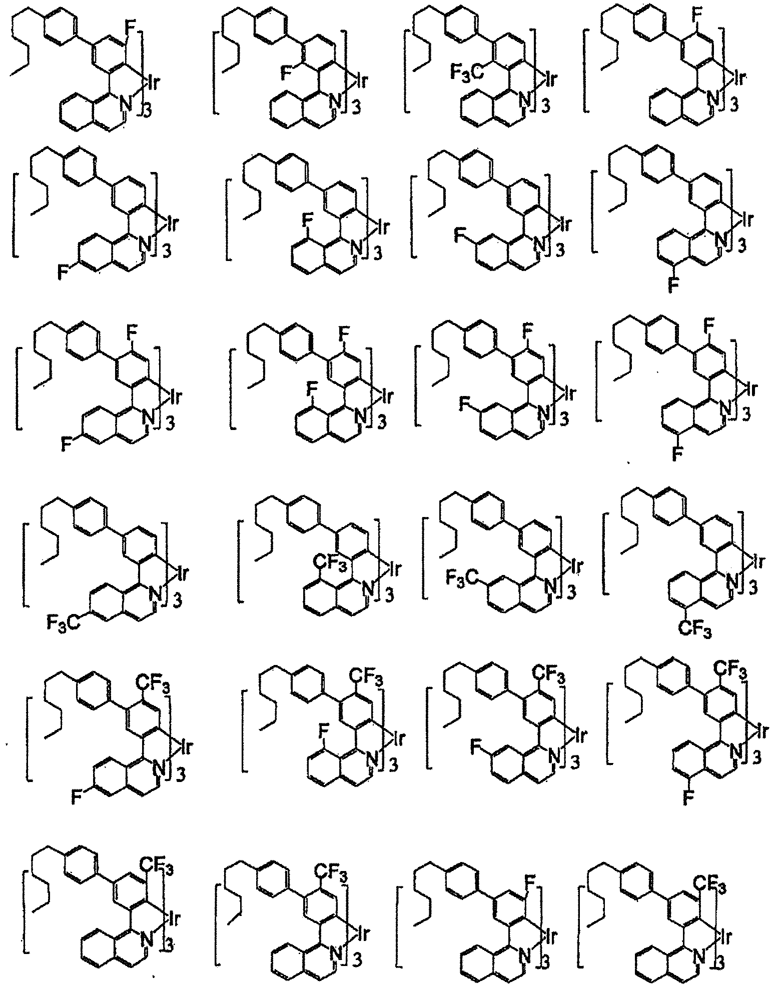

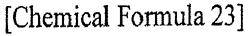

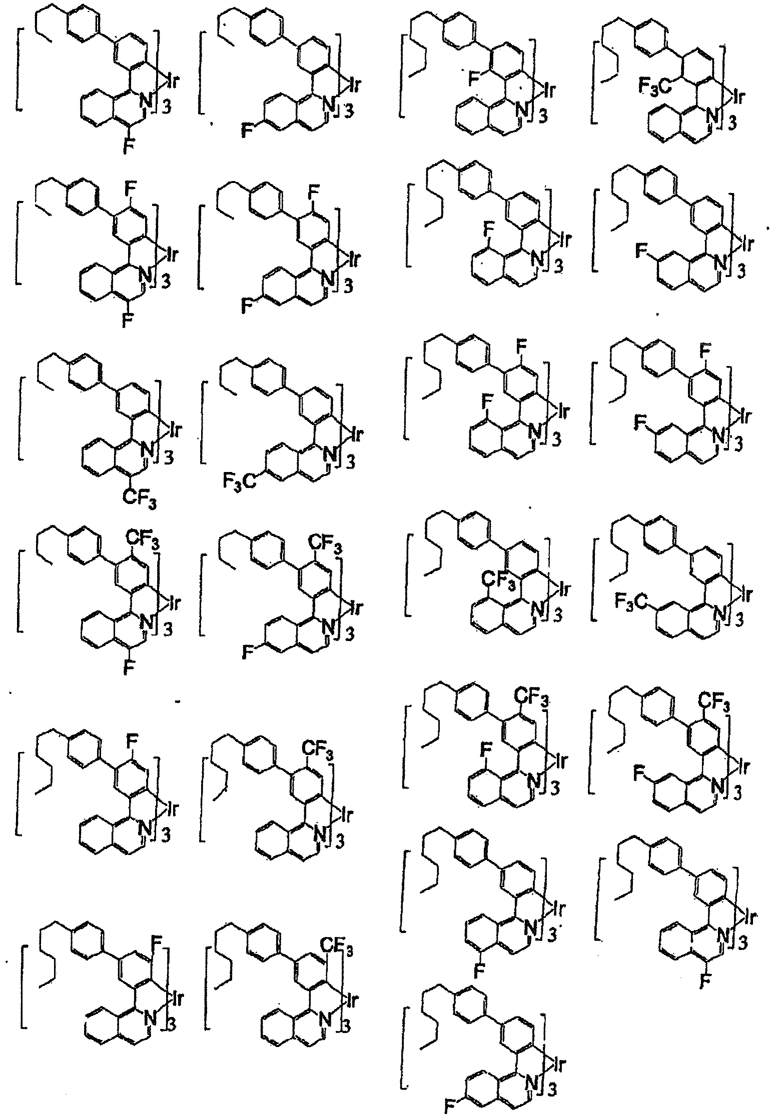

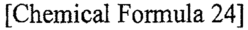

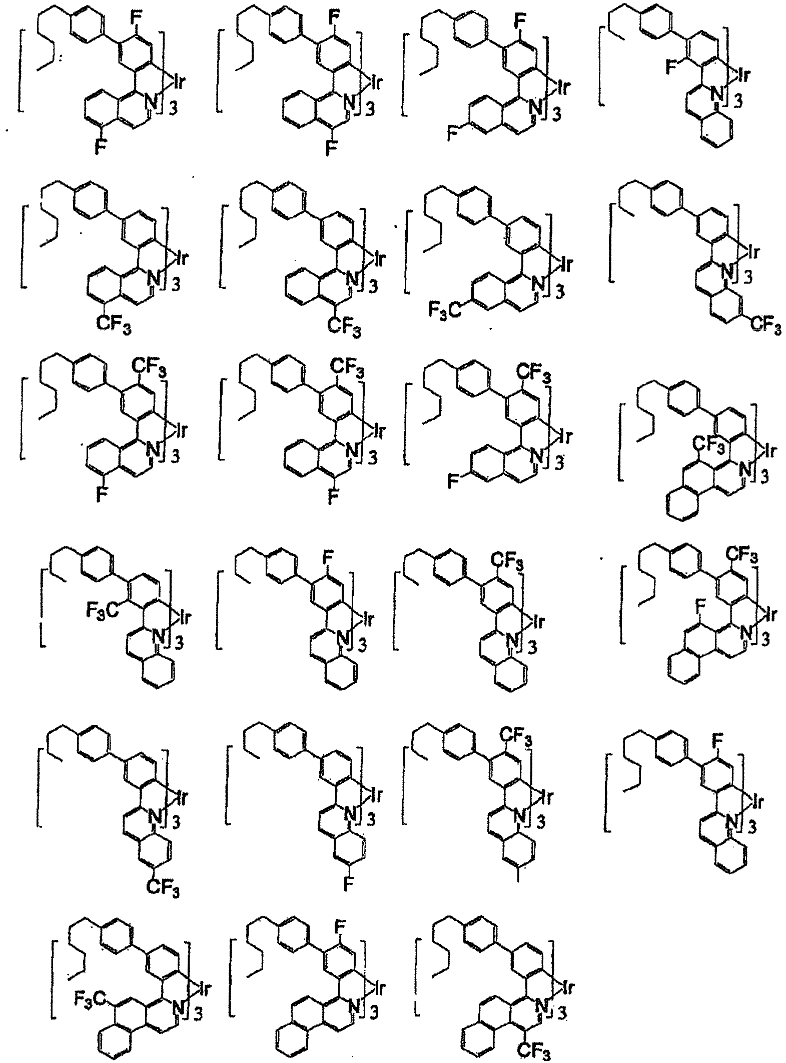

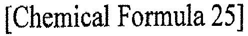

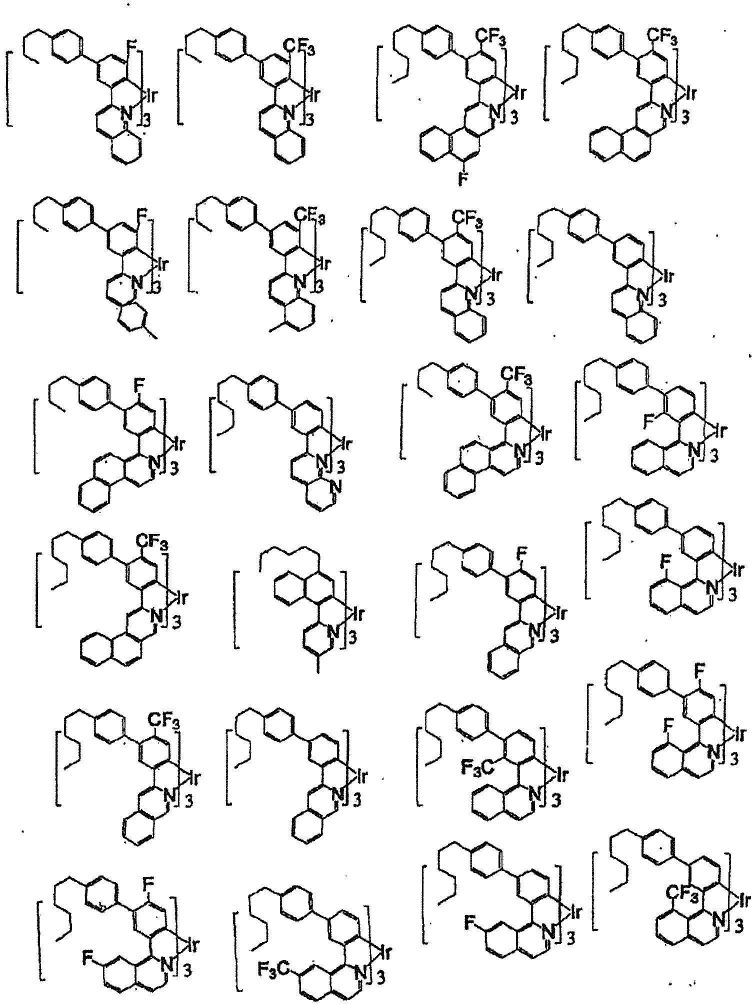

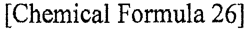

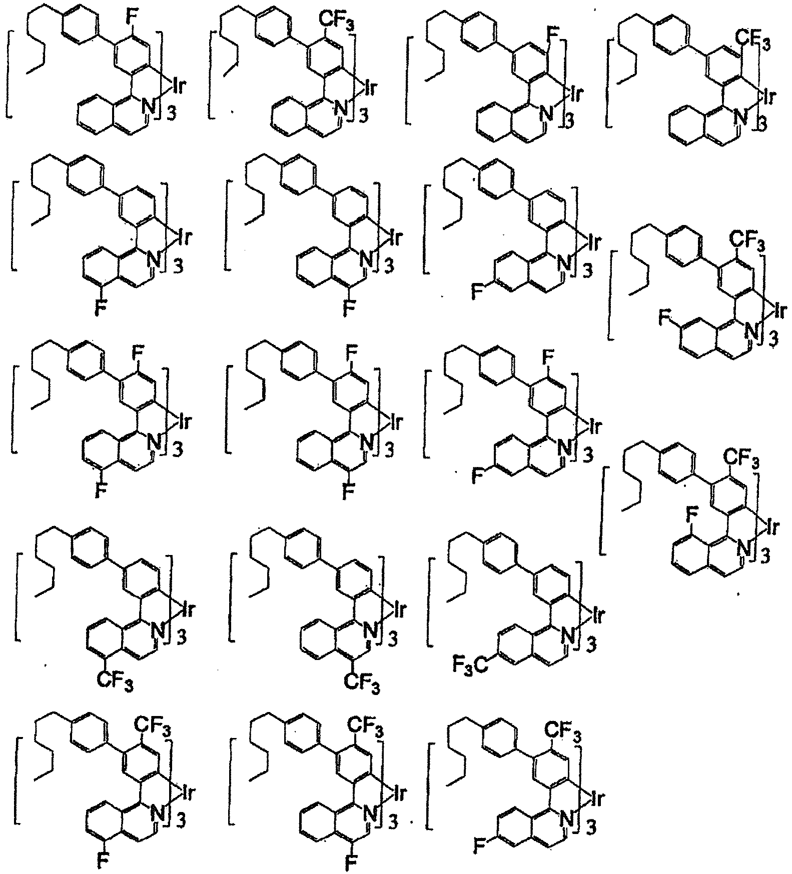

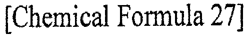

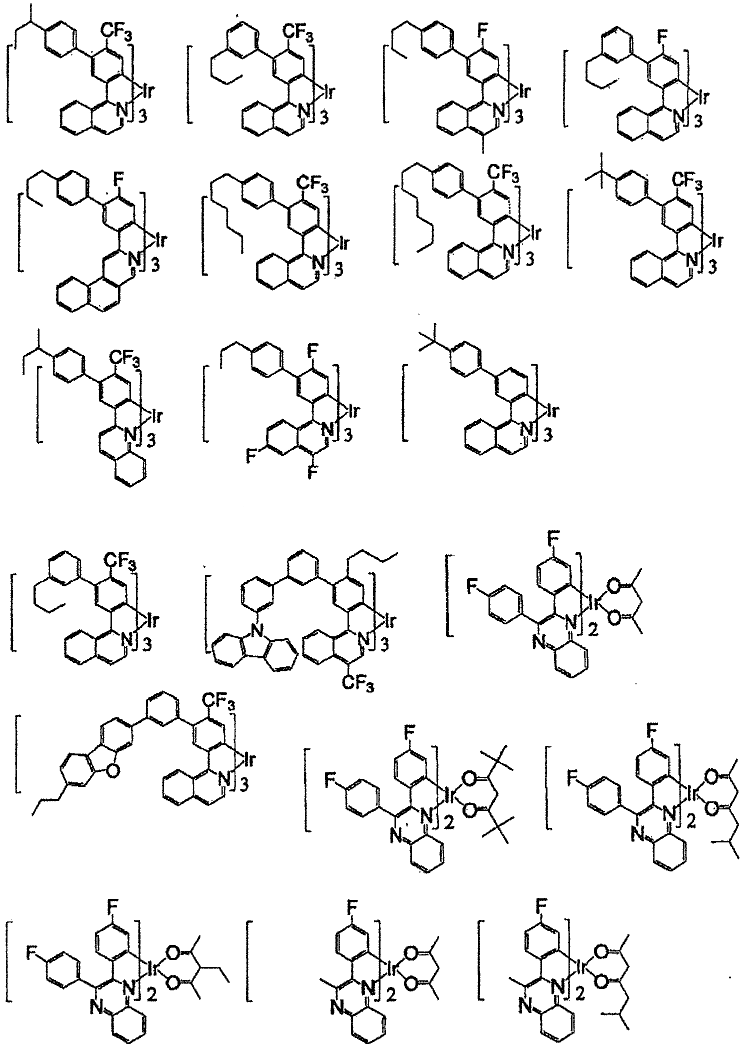

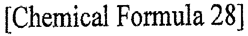

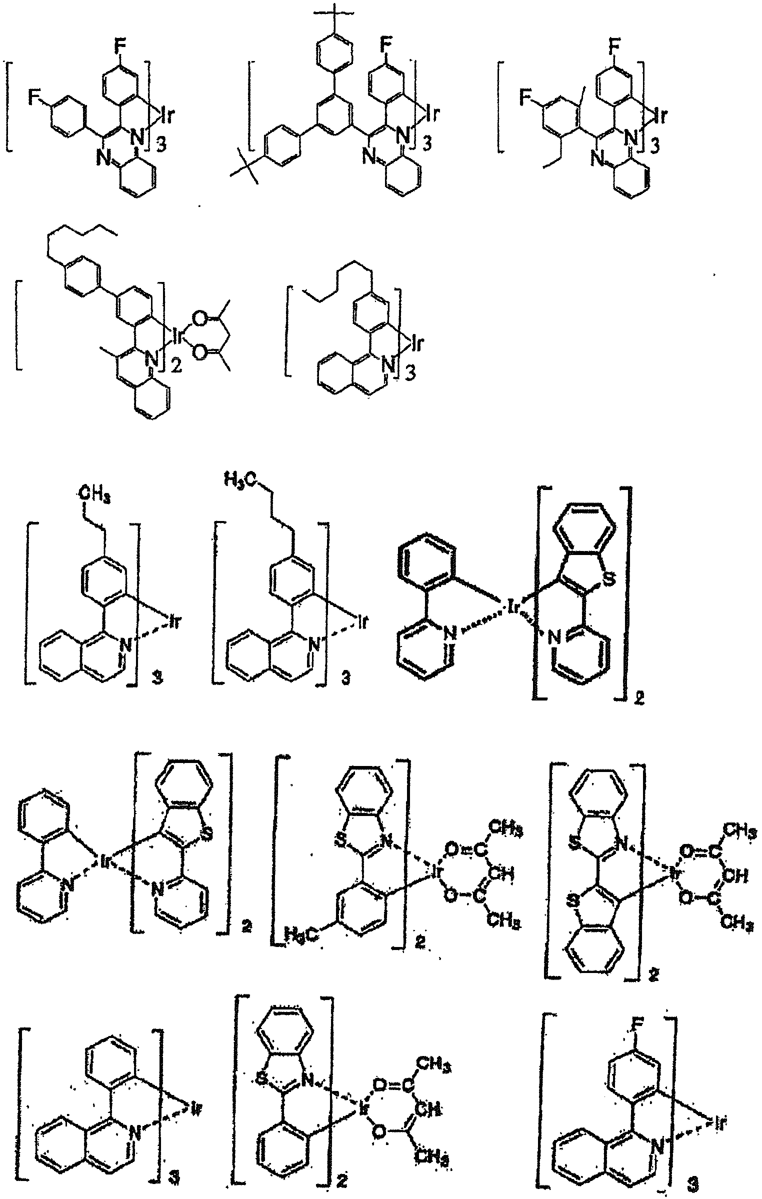

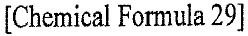

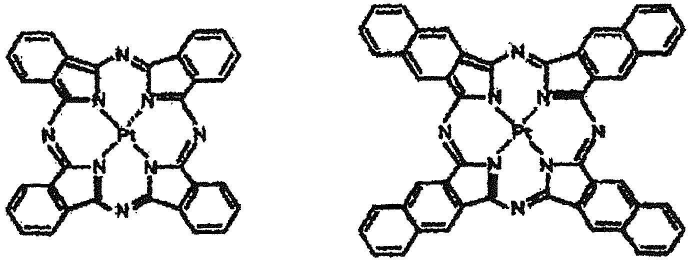

### Coated Light Emitting Layer

In the organic electroluminescent element of the present invention, the first light emitting layer (the layer on the anode side of the light emitting layer) is the coated light emitting layer.

Specifically, the phosphorescent-light emitting material generally has a large molecular weight, as described above. Suppose that the first light emitting layer is formed by using a vacuum vapor deposition process. In this case, because the air-borne phosphorescent-light emitting material molecules occurring in the vapor deposition have large heat energy, the molecules adhered to the outermost surface of the layer in the final stage of the vapor deposition step move on the layer surface, and aggregate to stabilize. It is thus believed that the aggregates of the phosphorescent-light emitting material molecules are present in larger numbers on the outermost layer than inside of the light emitting layer. The aggregates is believed to trap the excitons and charges present in the first light emitting layer and the second light emitting layer, and cause increase of driving voltage and lowering of luminescence efficiency in the element. It is therefore preferable to provide the first light emitting layer as the coated light emitting layer.

The molecular weight of the fluorescent-light emitting material is not as large as that of the phosphorescent-light emitting material. The air-borne fluorescent-light emitting material molecules adhered to the substrate in the vapor deposition step are thus believed to have relatively smaller heat energy, and move only slightly on the outermost surface of the layer (low probability of forming aggregates).

As used herein, "wet film forming method" refers to methods that use solvent-containing ink for deposition. Examples include spin coating, dip coating, die coating, bar coating, blade coating, roll coating, spray coating, capillary coating, nozzle printing, inkjet method, screen printing, gravure printing, flexography, and offset printing. Preferred for ease of patterning are nozzle printing, die coating, roll coating, spray coating, inkjet method, gravure printing, and flexography. Particularly preferred for obtaining a uniform film quality are nozzle printing, inkjet method, gravure printing, and flexography.

The coated light emitting layer is formed by using the wet film forming method, using a light emitting layer forming composition that contains the phosphorescent-light emitting material, the low-molecular-weight charge transport material, and a solvent.

### Solvent

The solvent is not particularly limited, as long as it can desirably dissolve the phosphorescent-light emitting material and the charge transport material (described later).

The solubility of the solvent is typically 0.01 weight% or more, preferably 0.05 weight% or more, further preferably 0.1 weight% or more for each of the phosphorescent-light emitting material and the charge transport material at ordinary temperature and ordinary pressure.

Specific examples of the solvent are listed below. The solvent is not limited to the following examples, provided that it does not interfere with the advantages of the present invention.
Alkanes such as n-decane, cyclohexane, ethylcyclohexane, decalin, and bicyclohexane
Aromatic hydrocarbons such as toluene, xylene, metysilene, cyclohexylbenzene, and tetralin
Halogenated aromatic hydrocarbons such as chlorobenzene, dichlorobenzene, and trichlorobenzene
Aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether
Aromatic esters such as phenyl acetate, phenyl propionate, methyl benzoate, ethyl benz oate, ethyl benzoate, propyl benzoate, and n-butyl benzoate
Alicyclic ketones such as cyclohexanone, cyclooctanone, and fenchone
Alicyclic alcohols such as cyclohexanol, and cyclooctanol
Aliphatic ketones such as methyl ethyl ketone, and dibutyl ketone
Aliphatic alcohols such as butanol, and hexanol
Aliphatic ethers such as ethylene glycol dimethyl ether, ethylene glycol diethyl ether, and propylene glycol-1-monomethyl ether acetate (PGMEA)

Preferred are alkanes and aromatic hydrocarbons.

These solvents may be used either alone, or in any combination and proportion of two or more.

In order to obtain a film of improved uniformity, it is preferable to evaporate the solvent from the liquid film at an appropriate rate immediately after the deposition. To this end, the boiling point of the solvent is typically 80°C or more, preferably 100°C or more, more preferably 120°C or more, and typically 270°C or less, preferably 250°C or less, more preferably 230°C or less.

The solvent may be used in any amount, provided that it is not detrimental to the advantages of the present invention. The solvent is used in preferably 10 weight parts or more, more preferably 50 weight parts or more, particularly preferably 80 weight parts or more, and preferably 99.95 weight parts or less, more preferably 99.9 weight parts or less, particularly preferably 99.8 weight parts or less with respect to 100 weight parts of the light emitting layer forming composition. When the solvent content in the light emitting layer forming composition is below these lower limits, the viscosity may become excessively high, and ease of deposition procedure may suffer. On the other hand, above the foregoing upper limits, a sufficient thickness cannot be provided for the film after the removal of the solvent following the deposition, and the deposition tends to become difficult. When two or more solvents are mixed and used as the light emitting layer forming composition, the solvent content satisfying the foregoing ranges is the total content of the solvents.

### Light Emitting Material

In the present invention, the coated light emitting layer is preferably a layer that has a maximum emission wavelength in at least two of the 440 to 500 nm region, 510 to 550 nm region, and 580 to 630 nm region. Accordingly, the coated light emitting layer preferably contains at least two of a blue emitting material having a maximum emission wavelength in the 440 to 500 nm region, a green emitting material having a maximum emission wavelength in the 510 to 550 nm region, and a red emitting material having a maximum emission wavelength in the 580 to 630 nm region, particularly preferably a green emitting material having a maximum emission wavelength in the 510 to 550 nm region, and a red emitting material having a maximum emission wavelength in the 580 to 630 nm region.

As described above, the coated light emitting layer contains the phosphorescent-light emitting material to obtain high luminescence efficiency. Preferably, the coated light emitting layer contains at least one of a red phosphorescent-light emitting material and a green phosphorescent-light emitting material.

This is because, when a layer of a narrow energy gap containing a red emitting material or a green emitting material is disposed on the anode side, energy transfer from the blue emitting material of a wide energy gap to the adjacent layer (for example, the hole transport layer) on the anode side of the light emitting layer can be suppressed.

The light emitting layer forming composition of the present invention contains the light emitting material in typically 0.01 weight% or more, preferably 0.05 weight% or more, further preferably 0.1 weight% or more, and typically 20 weight% or less, preferably 10 weight% or less, further preferably 5 weight% or less.

### Charge Transport Material

The light emitting layer forming composition used in the present invention further contains the charge transport material. Specifically, the coated light emitting layer contains the charge transport material.

The charge transport material is a compound for transporting charges such as holes and electrons, and is specified by a single molecular weight. Preferably, the light emitting layer according to the present invention contains the light emitting material as dopant material, and the charge transport material as host material.

The charge transport material may be a low-molecular-weight compound used for the light emitting layer of conventional organic electroluminescent elements, and is preferably a compound used as the host material of the light emitting layer.

Specific examples of the charge transport material include aromatic amine compounds, phthalocyanine compounds, porphyrin compounds, oligothiophene compounds, polythiophene compounds, benzylphenyl compounds, compounds joined to tertiary amine with a fluorene group, hydrazone compounds, silazane compounds, silanamine compounds, phosphamine compounds, quinacridone compounds, anthracene compounds, pyrene compounds, carbazole compounds, pyridine compounds, styryl compounds, phenanthroline compounds, oxadiazole compounds, and silole compounds.

The charge transport material can be broadly classified into hole transporting compounds and electron transporting compounds.

### Hole Transporting Compound

The coated light emitting layer may contain a hole transporting compound as a constituent material. Among a variety of hole transporting compounds, examples of low-molecular-weight hole transporting compounds include aromatic diamines, as represented by 4,4'-bis[N-(1-naphthyl)-N-phenylamino]biphenyl, that contain two or more tertiary amines, and in which the nitrogen atoms are attached to two or more condensed aromatic rings (JP-A-5-234681); aromatic amine compounds having a starburst structure, such as 4,4',4"-tris(1-naphthylphenylamino)triphenylamine (Journal of Luminescence, 1997, Vol. 72-74, pp. 985); aromatic amine compounds formed by a tetramer of triphenylamine (Chemical Communications, 1996, pp. 2175); and spiro compounds such as 2,2',7,7'-tetrakis-(diphenylamino)-9,9'-spirobifluorene (Synthetic Metals, 1997, Vol. 91, pp. 209).

In the coated light emitting layer, the hole transporting compound may be used either alone, or in any combination and proportion of two or more.

### Electron Transporting Compound

The coated light emitting layer may contain the electron transporting compound as a constituent material. Among a variety of electron transporting compounds, examples of low-molecular-weight electron transporting compounds include 2,5-bis(1-naphthyl)-1,3,4-oxadiazole (BND), 2,5-bis(6'-(2',2"-bipyridyl))-1,1-dimethyl-3,4-diphenylsilole (PyPySPyPy), bathophenanthroline (BPhen), 2,9-dimethyl-4,7-diphenyl-1,10-phenanthroline (BCP, bathocuproin), 2-(4-biphenylyl)-5-(p-tert-butylphenyl)-1,3,4-oxadiazole (tBu-PBD), and 4,4'-bis(9-carbazole)-biphenyl (CBP).

In the coated light emitting layer, the electron transporting compound may be used either alone, or in any combination and proportion of two or more.

The charge transport material may be used either alone, or in any combination and proportion of two or more. When used in a combination of two or more, it is preferable to use the hole transporting compound and the electron transporting compound in combination.

When the coated light emitting layer contains a red phosphorescent-light emitting material and a green emitting material, the charge transport material may be, for example, an aromatic amine compound, a compound joined to tertiary amine with a fluorene group, a carbazole compound, a pyridine compound, or a silole compound.

Specific examples of charge transport materials preferred for use in the present invention are given below. It should be noted, however, that the present invention is in no way limited to the following.

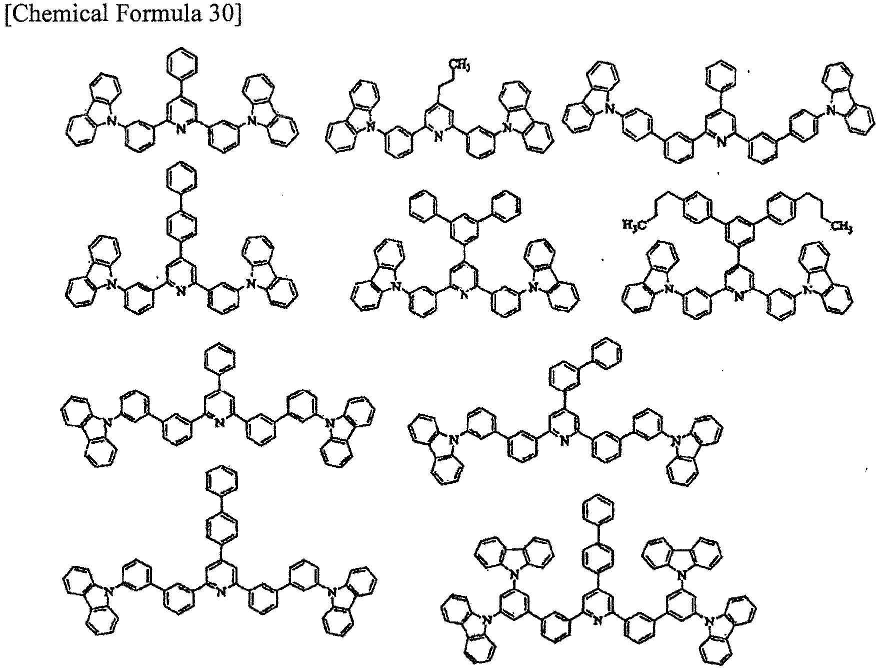

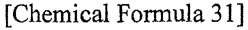

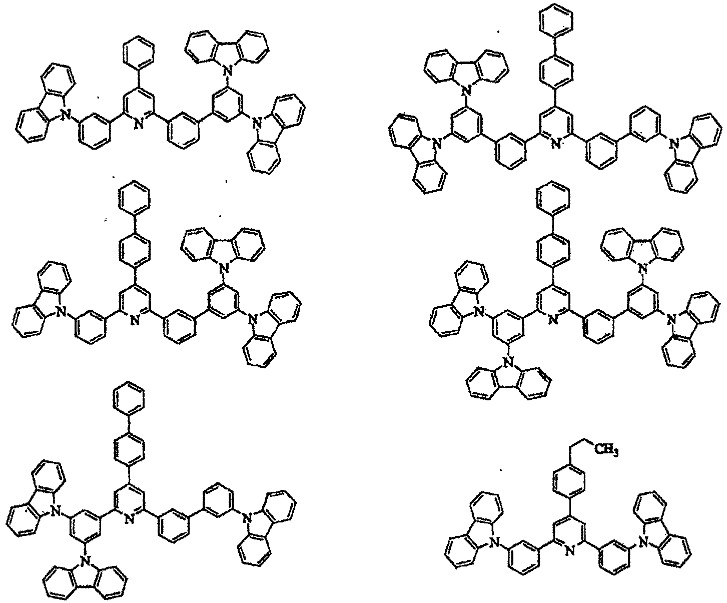

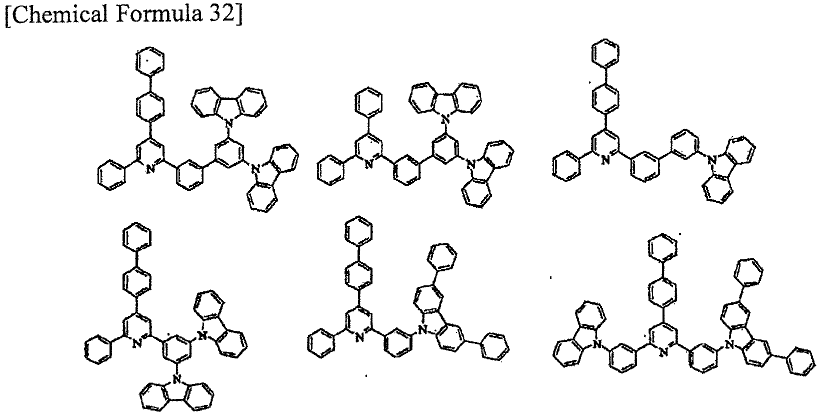

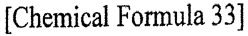

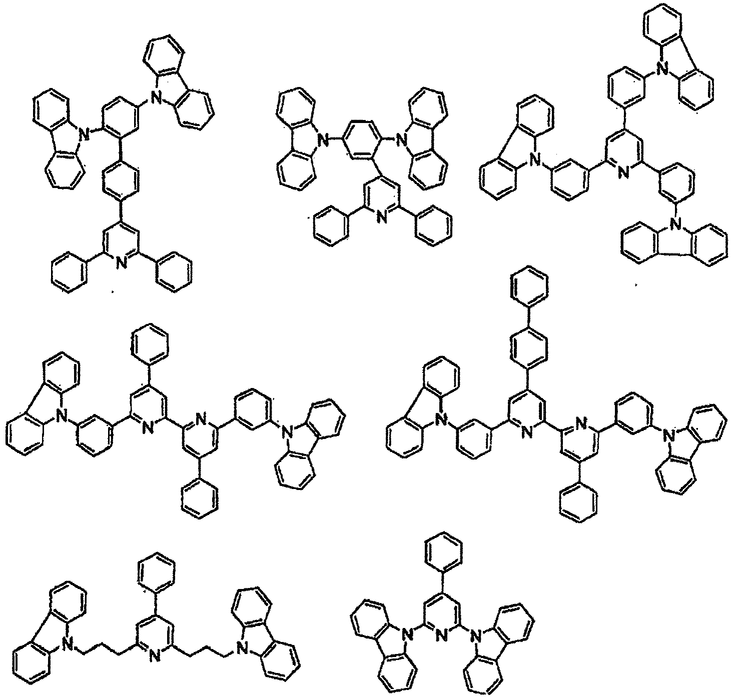

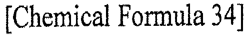

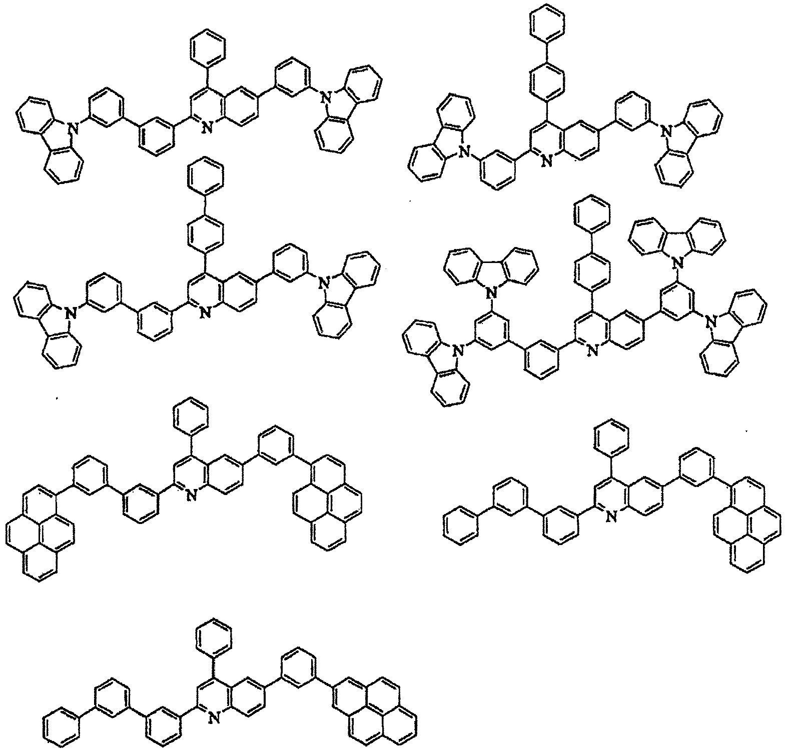

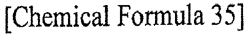

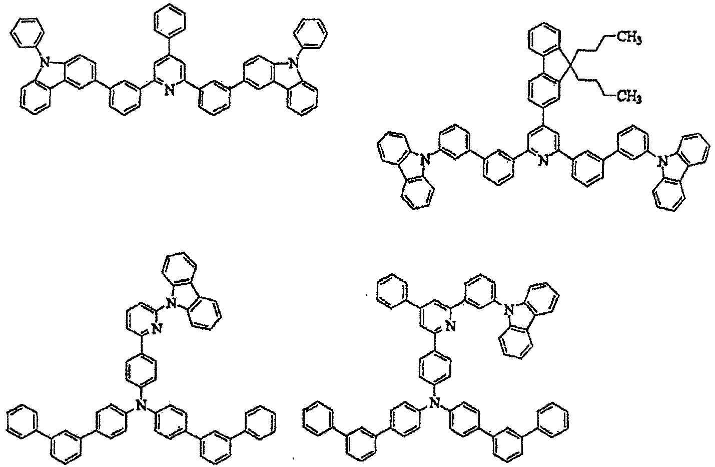

The light emitting layer forming composition of the present invention contains the charge transport material in typically 0.1 weight% or more, preferably 0.5 weight% or more, further preferably 1 weight% or more, and typically 20 weight% or less, preferably 10 weight% or less, further preferably 5 weight% or less.

The content ratio of the light emitting material and the charge transport material (light emitting material/charge transport material) in the light emitting layer forming composition is typically 0.01 or more, preferably 0.03 or more, and typically 0.5 or less, preferably 0.2 or less.

### Other Components

The light emitting layer forming composition of the present invention may contain other components, provided that these are not detrimental to the advantages of the present invention. Examples of such other components include components derived from the hole transport layer and the hole injection layer, coat improvers such as leveling agents, defoaming agents, and thickeners, charge transport auxiliary agents such as electron-accepting compounds and electron donating compounds, and binder resins, as will be described later. These additional components may be used either alone, or in any combination and proportion of two or more.

For considerations such as preventing overly interfering with the charge movement in the formed thin film (coated light emitting layer), and preventing interfering with the emission from the light emitting material, and preventing lowering of thin film quality, the content of the additional component in the coated light emitting layer is typically 5 weight% or less, preferably 1 weight% or less, more preferably 0.5 weight% or less, particularly preferably 0 weight% (not contained).

From the standpoint of the advantages of the present invention, it is preferable that all the materials contained in the coated light emitting layer are low molecular compounds, including the light emitting material and the charge transport material contained in the light emitting layer forming composition.

### Vapor Deposited Light Emitting Layer

In the organic electroluminescent element of the present invention, the second light emitting layer (the layer formed on the anode side of the light emitting layer via the first light emitting layer) is the vapor deposited light emitting layer.

As used herein, "vacuum deposition method" refers to methods that form a layer by evaporating a compound in a vacuum.

For preventing collision with the residual gas molecules inside the vacuum vapor deposition device, and lowering the evaporation temperature of the vapor deposition material for easy evaporation, it is preferable that the degree of vacuum is typically 10⁻² Pa or less and 10⁻⁶ or more, and 10⁻³ Pa or less and 10⁻⁵ or more.

For ease of vapor deposition, the vapor deposited light emitting layer of the present invention is provided as a layer that contains a fluorescent-light emitting material. Preferably, the vapor deposited light emitting layer contains at least a blue emitting material having a maximum emission wavelength in the 440 to 500 nm region.

### Charge Transport Material

The vapor deposited light emitting layer according to the present invention typically contains a charge transport material, in addition to the light emitting material.

The charge transport material contained in the vapor deposited light emitting layer is not particularly limited, as long as it does not interfere with the advantages of the present invention, and known low-molecular-weight materials may be used.

When the vapor deposited light emitting layer contains a blue fluorescent-light emitting material, it is particularly preferable to use the compound represented by the following formula (3) as the charge transport material because of durability. 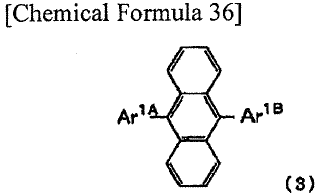 (In the formula (3), Ar^{1A} and Ar^{1B} each independently represent an aromatic hydrocarbon group that may have a substituent, or an aromatic heterocyclic group that may have a substituent. The anthracene ring in the formula (3) may have substituents other than Ar^{1A} and Ar^{1B}.)

Ar^{1A} and Ar^{1B} each independently represent an aromatic hydrocarbon group that may have a substituent, or an aromatic heterocyclic group that may have a substituent.

Examples of the aromatic hydrocarbon group represented by Ar^{1A} and AR^{1B} include groups derived from a benzene ring or fused rings of 2 to 5 benzene rings, such as a benzene ring, a naphthalene ring, a phenanthrene ring, an anthracene ring, a pyrene ring, a chrysene ring, a naphthacene ring, and a benzophenanthrene ring.

Specific examples of the aromatic heterocyclic group represented by Ar^{1A} and Ar^{1B} include groups derived from a furan ring, a benzofuran ring, a dibenzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a shinorine ring, a quinoxaline ring, a benzoimidazole ring, a perimidine ring, a quinazoline ring, a quinazolinone ring, an azulene ring, and the like.

The substituent of the aromatic hydrocarbon group represented by the Ar^{1A} and Ar^{1B} may be an organic group such as alkyl, an aromatic hydrocarbon group, an aromatic heterocyclic group, alkoxy, (hetero)aryloxy, alkylthio, (hetero)arylthio, cyano, dialkylamino, alkylarylamino, and diarylamino. For compound stability, alkyl and aromatic hydrocarbon group are preferred, and aromatic hydrocarbon group is particularly preferred. The term "(hetero)aryl" as used herein means both "aryl" and "heteroaryl". The term "aryl" as used herein means both "aromatic hydrocarbon group" and "aromatic heterocyclic group".

The alkyl as the substituent of the aromatic hydrocarbon group represented by Ar^{1A} and Ar^{1B} is preferably alkyl of 1 t 20 carbon atoms. Examples include methyl, ethyl, propyl, iso-propyl, butyl, iso-butyl, sec-butyl, tert-butyl, hexyl, octyl, cyclohexyl, decyl, and octadecyl. Methyl, ethyl, iso-propyl, sec-butyl, and tert-butyl are preferred. Methyl and ethyl are preferred for their wide availability as raw material, and cost. Iso-butyl, sec-butyl, and tert-butyl are preferred for their high solubility in nonpolar solvents.

The aromatic hydrocarbon group is preferably of 6 to 25 carbon atoms, and is preferably an aromatic hydrocarbon group derived from a single ring or 2 to 5 fused rings of six-membered rings. Examples include groups derived from a benzene ring, a naphthalene ring, an anthracene ring, a phenanthrene ring, a perylene ring, a tetracene ring, a pyrene ring, a benzopyrene ring, a chrysene ring, a triphenylene ring, a fluoranthene ring, and the like.

The aromatic heterocyclic group is preferably of 3 to 20 carbon atoms. Examples include groups derived from a furan ring, a benzofuran ring, a dibenzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a shinorine ring, a quinoxaline ring, a benzoimidazole ring, a perimidine ring, a quinazoline ring, a quinazolinone ring, an azulene ring, and the like.

The alkoxy is preferably of 1 to 20 carbon atoms. Examples include methoxy, ethoxy, isopropyloxy, cyclohexyloxy, and octadecyloxy.

The (hetero)aryloxy is preferably of 3 to 20 carbon atoms. Examples include phenoxy, 1-naphthyloxy, 9-anthraniloxy, and 2-thienyloxy.

The alkylthio is preferably of 1 to 20 carbon atoms. Examples include methylthio, ethylthio, isopropylthio, and cyclohexylthio.

The (hetero)arylthio is preferably of 3 to 20 carbon atoms. Examples include phenylthio, 1-naphthylthio, 9-anthranilthio, and 2-thienylthio.

The dialkylamino is preferably of 2 to 29 carbon atoms. Examples include diethylamino, diisopropylamino, and methylethylamino.

The alkylarylamino is preferably of 7 to 30 carbon atoms. Examples include methylphenylamino.

The diarylamino is preferably of 12 to 30 carbon atoms. Examples include diphenylamino, and phenylnaphthylamino.

These substituents may be further substituted. Examples of such further substituents include the alkyl, aryl, alkoxy, and diarylamino exemplified above. The case where the substituents are bound to each other to form a ring, is excepted.

Specific examples of the charge transport material preferably contained in the vapor deposited light emitting layer are given below. It should be noted, however, that the present invention is not limited to these.

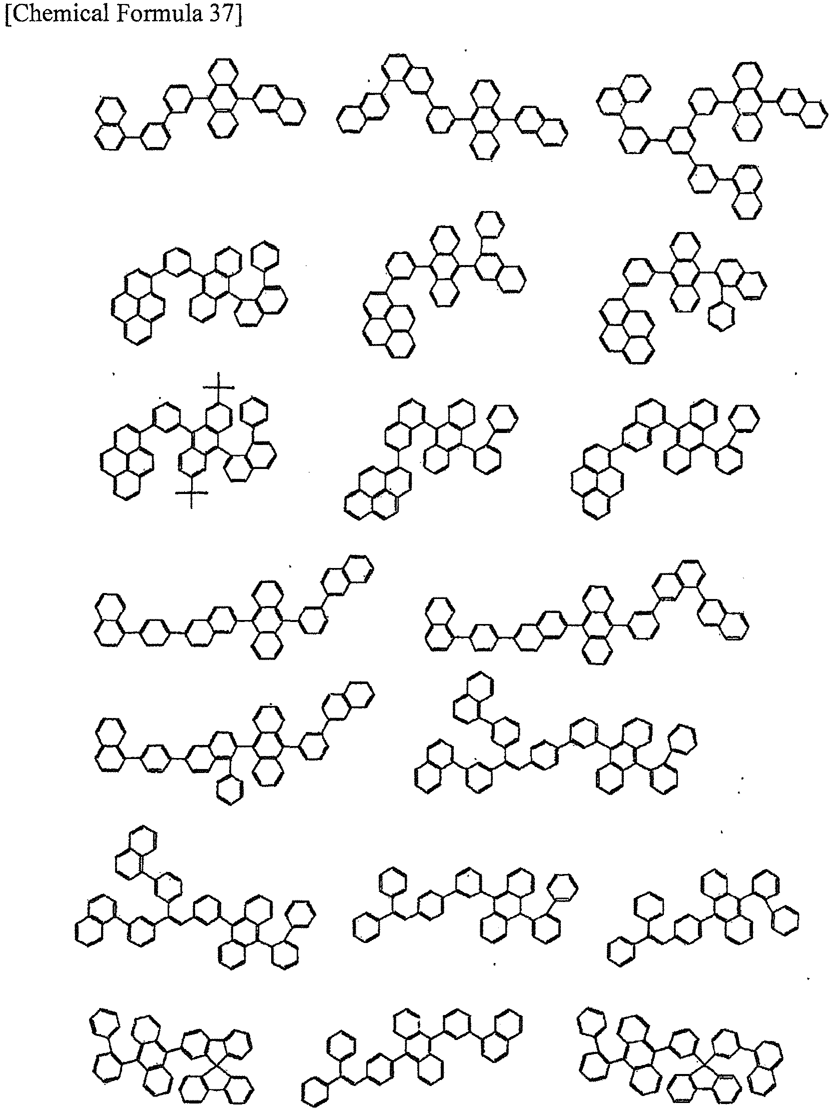

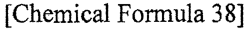

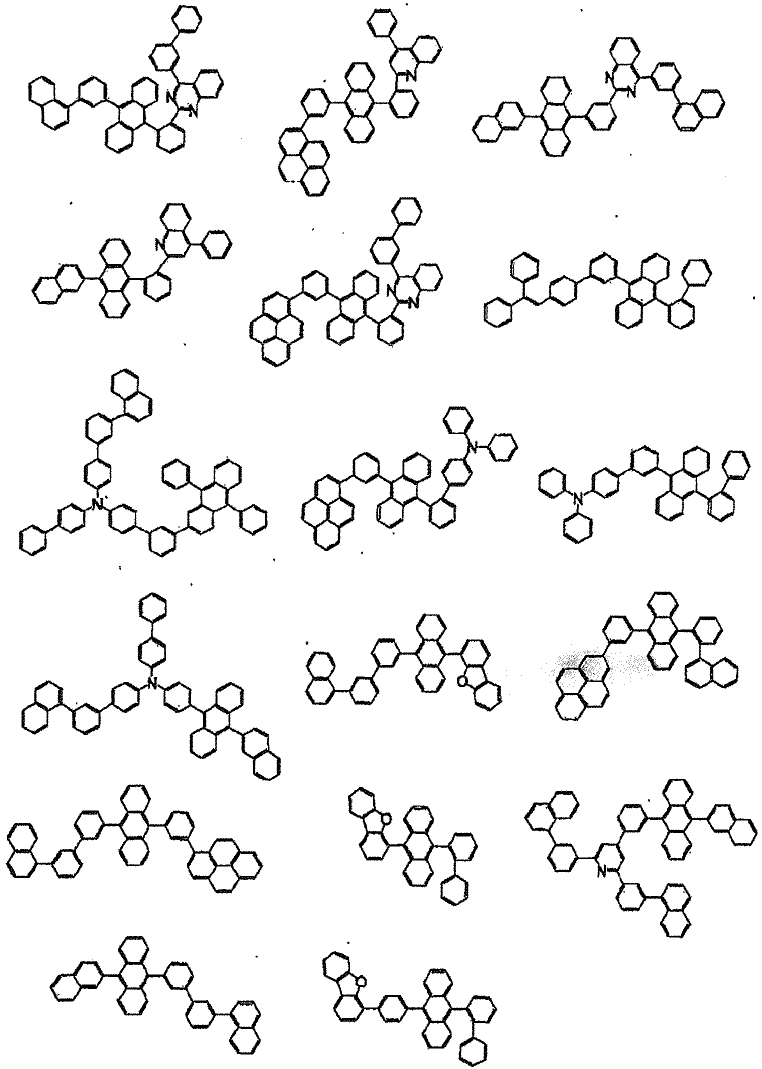

The charge transport material may be used either alone, or in any combination and proportion of two or more.

### Other Components

The vapor deposited light emitting layer of the present invention may contain other components, provided that these do not interference with the advantages of the present invention. The other components may be the same components described in the Coated Light Emitting Layer section and the Other Components section.

### Component Content

The vapor deposited light emitting layer of the present invention contains the light emitting material in typically 0.001 weight% or more, preferably 0.005 weight% or more, further preferably 0.01 weight% or more, and typically 30 weight% or less, preferably 20 weight% or less, further preferably 15 weight% or less.

The vapor deposited light emitting layer of the present invention contains the charge transport material in typically 0.001 weight% or more, and typically 99.999 weight% or less, preferably 99.995 weight% or less, further preferably 99.99 weight% or less.

The content ratio of the light emitting material and the charge transport material (light emitting material/charge transport material) in the vapor deposited light emitting layer is typically 0.01 or more, preferably 0.03 or more, and typically 0.5 or less, preferably 0.2 or less.

When the vapor deposited light emitting layer of the present invention contains an additional component, the additional component is contained in typically 5 weight% or less, preferably 1 weight% or less, more preferably 0.5 weight% or less, particularly preferably 0 weight% (not contained) for considerations such as preventing overly interfering with the charge movement in the formed thin film (vapor deposited light emitting layer), and preventing interfering with the emission from the light emitting material, and preventing lowering of thin film quality.

From the standpoint of the advantages of the present invention, it is preferable that all the materials contained in the light emitting layer are low molecular compounds, including the light emitting material and the charge transport material contained in the vapor deposited light emitting layer.

### Interlayer

For the purpose of suppressing energy transfer between the coated light emitting layer and the vapor deposited light emitting layer, a non-emitting interlayer laminated by a vacuum deposition method using a charge transport material may be used between the coated light emitting layer and the vapor deposited light emitting layer of the organic electroluminescent element of the present invention. (Preferably, the interlayer is not provided from the standpoint of driving voltage.)

The charge transport material used for the non-emitting interlayer may be the same charge transport material contained in the coated light emitting layer and/or the vapor deposited light emitting layer, or a different charge transport material. Preferably, the charge transport material used for the non-emitting interlayer is the same charge transport material contained in at least one of the two adjacent light emitting layers. From the standpoint of the advantages of the present invention, it is preferable that the charge transport material used for the interlayer is a low molecular compound.

The interlayer may be a hole relaxation layer (described later).

### Thickness

In the light emitting layer according to the present invention, the coated light emitting layer has a thickness of preferably 2 to 100 nm, particularly 3 to 60 nm from the standpoint of lowering the driving voltage of the product element.

The vapor deposited light emitting layer has a thickness of 2 to 100 nm, particularly 3 to 100 nm from the standpoint of lowering the driving voltage of the product element.

When the light emitting layer includes the interlayer, the interlayer thickness is preferably 1 nm to 50 nm, more preferably 3 nm to 10 nm. The current-voltage characteristics of the element will not be greatly affected when the interlayer thickness is confined in these ranges.

From the standpoint of lowering the driving voltage of the product element, and improving the stability of the emitted colors, the total thickness of the light emitting layer according to the present invention (the total thickness of the coated light emitting layer and the vapor deposited light emitting layer, plus the thickness of the interlayer when it is used) is preferably 5 to 100 nm, particularly preferably 10 to 80 nm.

### Layer Configuration of Organic Electroluminescent Element

The layer configuration of the organic electroluminescent element of the present invention, and the general method of forming the organic electroluminescent element are described below with reference to FIG. 1.

FIG. 1 is a schematic cross sectional diagram representing an exemplary structure of an organic electroluminescent element 10 of the present invention. Referring to FIG. 1, the organic electroluminescent element 10 includes a substrate 1, an anode 2, a hole injection layer 3, a hole transport layer 4, a light emitting layer 5, a hole blocking layer 6, an electron transport layer 7, an electron injection layer 8, and a cathode 9.

### Substrate

The substrate 1 serves as the base of the organic electroluminescent element, and materials such as a quartz or glass plate, a metal board or a metal foil, and a plastic film or sheet are used. It is particularly preferable to use a glass plate, and a transparent plate of synthetic resins such as polyester, polymethacrylate, polycarbonate, and polysulfone. When synthetic resin is used for the substrate, care must be taken for the gas barrier property. When the gas barrier property of the substrate is too low, ambient air passes through the substrate, and deteriorates the organic electroluminescent element. In a preferred method, a dense silicon oxide film or the like is provided on at least one side of the synthetic resin substrate to ensure a sufficient gas barrier property.

### Anode

The anode 2 has a role of injecting holes to the layer on the side of the light emitting layer 5.

The anode 2 is typically formed by using materials such as metal (e.g., aluminum, gold, silver, nickel, palladium, platinum, etc.), metal oxides (e.g., indium and tin oxide), halogenated metal (e.g., copper iodide), and conductive polymer (e.g., carbon black, poly(3-methylthiophene), polypyrrole, and polyaniline).

The anode 2 is formed typically by using a method such as sputtering, and vacuum vapor deposition. When forming the anode 2 by using materials such as silver or other metallic fine particles, fine particles of copper iodide or the like, carbon black, conductive metal oxide fine particles, and a conductive polymer fine powder, these may be dispersed in a suitable binder resin solution, and applied to the substrate 1 to form the anode 2. In the case of conductive polymer, the anode 2 may be formed by directly forming a thin film on the substrate 1 by electrolytic polymerization, or by applying a conductive polymer onto the substrate 1 (Appl. Phys. Lett., Vol. 60, p. 2711, 1992).

The anode 2 typically has a monolayer structure. However, the anode 2 may have a laminate structure of more than one material, as desired.

The thickness of the anode 2 depends on the required transparency. When transparency is required, it is desirable to have a visible light transmittance of typically 60% or more, preferably 80% or more. In this case, the thickness of the anode 2 is typically about 5 nm or more, preferably about 10 nm or more, and typically about 1,000 nm or less, preferably about 500 nm or less. When transparency is not required, the anode 2 may have any thickness, and may have the same thickness as the substrate 1. Different conductive materials may be laminated on the anode 2.

For the purpose of removing the impurities adhered to the anode 2, and adjusting the ionization potential and improving the hole injectability, it is preferable to subject the surface of the anode 2 to a ultraviolet (UV)/ozone treatment, an oxygen plasma treatment or, an argon plasma treatment.

### Hole Injection Layer

The hole injection layer 3 is provided to transport holes from the anode 2 to the light emitting layer 5, and is typically formed on the anode 2.

The method used to form the hole injection layer 3 in the present invention is not particularly limited, and may be a vacuum deposition method or a wet film forming method. However, from the standpoint of reducing dark spots, it is preferable to form the hole injection layer 3 by using a wet film forming method.

The thickness of the hole injection layer 3 is typically 5 nm or more, preferably 10 nm or more, and typically 1,000 nm or less, preferably 500 nm or less.

### Formation of Hole Injection Layer by Wet film forming method

When a wet film forming method is used, the hole injection layer 3 is typically formed as follows. The material of the hole injection layer 3 is mixed with a suitable solvent (hole injection layer solvent) to prepare a deposition composition (hole injection layer forming composition). The composition for forming the hole injection layer 3 is then applied and deposited onto the underlayer (typically, the anode 2) of the hole injection layer by using a suitable technique. The composition is then dried to form the hole injection layer 3.

### Hole Transporting Compound

The hole injection layer forming composition typically contains a hole transporting compound and a solvent as constituent materials of the hole injection layer 3.

Typically, the hole transporting compound may be a high molecular compound such as polymer, or a low molecular compound such as monomer, as long as it is capable of transporting holes and usable for the hole injection layer 3 of the organic electroluminescent element. Preferably, the hole transporting compound is a high molecular compound.

From the standpoint of the charge injection barrier between the anode 2 and the hole injection layer 3, the hole transporting compound is preferably a compound having an ionization potential of 4.5 eV to 6.0 eV. Examples of the hole transporting compound include aromatic amine derivatives, phthalocyanine derivatives, porphyrin derivatives, oligothiophene derivatives, polythiophene derivatives, benzylphenyl derivatives, compounds joined to tertiary amine with a fluorene group, hydrazone derivatives, silazane derivatives, silanamine derivatives, phosphamine derivatives, quinacridone derivatives, polyaniline derivatives, polypyrrole derivatives, polyphenylenevinylene derivatives, polythienylenevinylene derivatives, polyquinoline derivatives, polyquinoxaline derivatives, and carbon.

Taking an aromatic amine derivative as an example, the term "derivative" as used herein refers to compounds that contain the aromatic amine itself, or that contain a compound having an aromatic amine backbone, and may be a polymer or a monomer.

The hole transporting compound used as the material of the hole injection layer 3 may contain such compounds either alone or in a combination of two or more. When two or more hole transporting compounds are contained, the hole transporting compounds may be used in any combination. Preferably, one or more aromatic tertiary amine polymer compounds are used in combination with one or more other hole transporting compounds.

Of the foregoing examples, aromatic amine compounds are preferred, and aromatic tertiary amine compounds are particularly preferred from the standpoint of amorphous property, and visible light transmittance. Here, aromatic tertiary amine compounds are compounds having an aromatic tertiary amine structure, and encompass compounds having a group derived from aromatic tertiary amines.

The type of aromatic tertiary amine compound is not particularly limited, and is preferably a polymer compound having a weight average molecular weight of 1,000 or more and 1,000,000 or less (a polymerizable compound with a repeating unit) from the standpoint of obtaining uniform emission by the surface smoothing effect. Preferred examples of the aromatic tertiary amine polymer compound include polymer compounds having the repeating unit of the following formula (I). 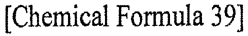 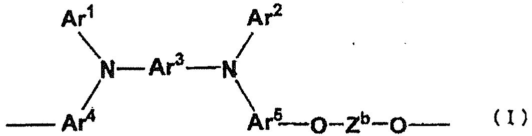 (In the formula (I), Ar¹ and Ar² each independently represent an aromatic hydrocarbon group that may have a substituent, or an aromatic heterocyclic group that may have a substituent. Ar³ to Ar⁵ each independently represent an aromatic hydrocarbon group that may have a substituent, or an aromatic heterocyclic group that may have a substituent. Z^{b} represents a linking group selected from the group of linking groups below. Two of the Ar¹ to Ar⁵ bound to the same nitrogen atom may be bound to each other to form a ring. 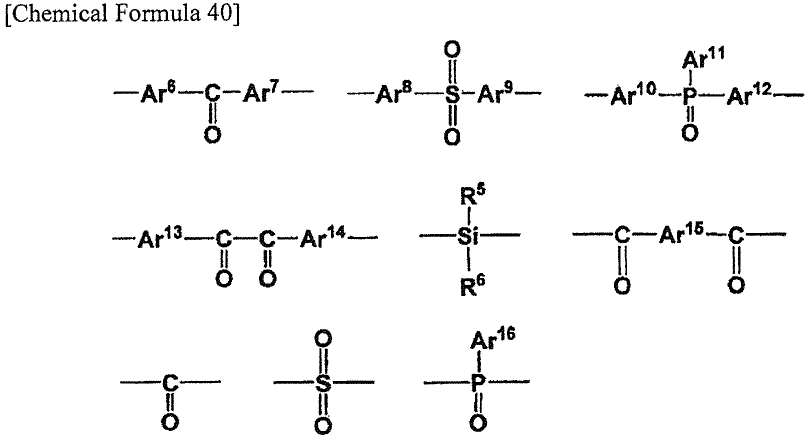 (In each formula, Ar⁶ to Ar¹⁶ each independently represent an aromatic hydrocarbon group that may have a substituent, or an aromatic heterocyclic group that may have a substituent. R⁵ and R⁶ each independently represent a hydrogen atom or any substituent.))

From the standpoint of the solubility, the heat resistance, and the hole injectability and transportability of the polymer compound, the aromatic hydrocarbon group and the aromatic heterocyclic group represented by Ar¹ to Ar¹⁶ are preferably groups derived from a benzene ring, a naphthalene ring, a phenanthrene ring, a thiophene ring, and a pyridine ring, further preferably groups derived from a benzene ring, and a naphthalene ring.

The aromatic hydrocarbon group and the aromatic heterocyclic group represented by Ar¹ to Ar¹⁶ may be further substituted. The molecular weight of the substituent is typically about 400 or less, preferably about 250 or less. Preferred examples of the substituent include alkyl, alkenyl, alkoxy, aromatic hydrocarbon group, and aromatic heterocyclic group.

When R⁵ and R⁶ are any substituent, examples of the substituent include alkyl, alkenyl, alkoxy, silyl, siloxy, aromatic hydrocarbon group, and aromatic heterocyclic group.

Specific examples of the aromatic tertiary amine polymer compound having the repeating unit of formula (I) include the compounds described in WO2005/089024.

Also preferred as the hole transporting compound is a conductive polymer (PEDOT/PSS) obtained by polymerizing 3,4-ethylenedioxythiophene(3,4-ethylenedioxythiophene) (a derivative of polythiophene) in high molecular polystyrene sulfonate. The polymer may be one in which the terminals are capped with methacrylate or the like.

The hole transporting compound may be a crosslinking compound as described in the Hole Transport Layer section below. The same deposition methods described above also may be used for the crosslinking compound.

The hole transporting compound in the hole injection layer forming composition may have any concentration, as long as it is not detrimental to the advantages of the present invention. However, from the standpoint of thickness uniformity, the concentration of the hole transporting compound is typically 0.01 weight% or more, preferably 0.1 weight% or more, further preferably 0.5 weight% or more, and typically 70 weight% or less, preferably 60 weight% or less, further preferably 50 weight% or less. Non-uniform thickness may occur when the concentration is too high. When too low, defects may occur in the deposited hole injection layer.

### Electron-Accepting Compound

The hole injection layer forming composition preferably contains an electron-accepting compound as a constituent material of the hole injection layer 3.

The electron-accepting compound is preferably an oxidative compound capable of accepting electrons from the hole transporting compound. Specifically, a compound with an electron affinity of 4 eV or more is preferred, and a compound with an electron affinity of 5 eV or more is further preferred.

Examples of such electron-accepting compounds include one or more compounds selected from the group consisting of triaryl boron compounds, halogenated metals, Lewis acids, organic acids, onium salts, salts of arylamine and halogenated metal, and salts of arylamine and Lewis acid. Specific examples include onium salts with substituted organic groups, such as 4-isopropyl-4'-methyldiphenyl iodonium tetrakis(pendafluorophenyl)borate, and triphenylsulfoniumtetrafluoroborate (WO2005/089024); high-valent inorganic compounds such as iron(III) chloride (JP-A-11-251067), and ammonium peroxodisulfate; cyano compounds such as tetracyanoethylene, and aromatic boron compounds such as tris(pendafluorophenyl)borane (JP-A-2003-31365); fullerene derivatives; iodine; and sulfonic acid ions such as polystyrene sulfonate ions, alkylbenzene sulfonic acid ions, and camphor sulfonic acid ions.

The electron-accepting compound can improve the conductivity of the hole injection layer 3 by oxidizing the hole transporting compound.

The content of the electron-accepting compound in the hole injection layer 3 or in the hole injection layer forming composition is typically 0.1 mol% or more, preferably 1 mol% or more with respect to the hole transporting compound. The content is typically 100 mol% or less, preferably 40 mol% or less.

### Other Constituent Materials

Components other than the hole transporting compound and the electron-accepting compound may be contained as material of the hole injection layer 3, provided that these are not detrimental to the advantages of the present invention. Examples of such other components include various light emitting materials, electron transporting compounds, binder resins, and coat improvers. These additional components may be used either alone, or in any combination and proportion of two or more.

### Solvent

Preferably, at least one of the solvents of the hole injection layer forming composition used in the wet deposition is a compound that can dissolve the constituent material of the hole injection layer 3. The solvent has a boiling point of typically 110°C or more, preferably 140°C or more, more preferably 200°C or more, and typically 400°C or less, preferably 300°C or less. When the boiling point of the solvent is too low, the drying rate may become too fast, and the film quality may deteriorate. An excessively high solvent boiling point requires increasing the temperature of the drying step. This may have adverse effects on the other layers and the substrate.

Examples of the solvent include ether solvents, ester solvents, aromatic hydrocarbon solvents, and amide solvents.

Examples of the ether solvents include aliphatic ethers such as ethylene glycol dimethyl ether, ethylene glycol diethyl ether, and propylene glycol-1-monomethyl ether acetate (PGMEA); and aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole.

Examples of the ester solvents include aromatic esters such as phenyl acetate, phenyl propionate, methyl benzoate, ethyl benzoate, propyl benzoate, and n-butyl benzoate.

Examples of the aromatic hydrocarbon solvents include toluene, xylene, cyclohexylbenzene, 3-iropropylbiphenyl, 1,2,3,4-tetramethylbenzene, 1,4-diisopropylbenzene, cyclohexylbenzene, and methylnaphthalene.

Examples of the amide solvents include N,N-dimethylformamide, and N,N-dimethylacetamide.

Compounds such as dimethylsulfoxide also may be used.

These solvents may be used either alone, or in any combination and proportion of two or more.

### Deposition Method

After preparing the hole injection layer forming composition, the composition is applied and deposited on the underlayer (typically, the anode 2) of the hole injection layer 3 by using a wet film forming method, and dried to form the hole injection layer 3.

The temperature of the coating step is preferably 10°C or more, and 50°C or less to prevent damage to the film due to formation of crystals in the composition.

The relative humidity in the coating step is not particularly limited, as long as it is not detrimental to the advantages of the present invention, and is typically 0.01 ppm or more, typically 80% or less.

After being applied, the hole injection layer forming composition film is dried, typically by heating. The heating means used in the heating step may be, for example, a clean oven, a hot plate, infrared, a halogen heater, or microwave irradiation. A clean oven and a hot plate are preferably used to evenly apply heat to the whole film.

The heating temperature in the heating step is preferably equal to or greater than the boiling point of the solvent used for the hole injection layer forming composition, as long as it is not detrimental to the advantages of the present invention. When the solvent used for the hole injection layer is a mixed solvent of two or more solvents, it is preferable to heat at least one of the solvents at a temperature equal to or greater than the boiling point of the solvent. Considering increase of the solvent boiling point, heating in the heat step is performed preferably at 120°C or more, preferably 410°C or less.

The heating time in the heating step is not particularly limited, provided that the heating temperature is equal to or greater than the boiling point of the solvent of the hole injection layer forming composition, and that the coating is not insolubilized to a sufficient degree. However, heating time is preferably 10 seconds or more, typically 180 minutes or less. When the heating time is too long, the components of the other layers tend to diffuse. When too short, the hole injection layer tends to be non-uniform. Heating may be performed as two separate procedures.

### Formation of Hole Injection Layer 3 by Vacuum deposition method

When forming the hole injection layer 3 by using a vacuum vapor deposition, one or more constituent materials (such as the hole transporting compound, and the electron-accepting compound) of the hole injection layer 3 are placed in a crucible installed in a vacuum chamber (in separate crucibles when two or more materials are used), and inside of the vacuum chamber is evacuated with a suitable vacuum pump to about 10⁻⁴ Pa. The crucible (each of the crucibles when two or more materials are used) is heated to evaporate the content in controlled evaporation amounts (evaporation amounts are independently controlled when two or more materials are used), and form the hole injection layer 3 on the anode 2 formed on the substrate 1 disposed opposite the crucible. When two or more materials are used, the hole injection layer 3 may be formed by heating and evaporating the mixture of these materials placed in a crucible.

The degree of vacuum in the vapor deposition is not particularly limited, as long as it is not detrimental to the advantages of the present invention, and is typically 0.1 × 10⁻⁶ Torr (0.13 × 10⁻⁴ Pa) or more, typically 9.0 × 10⁻⁶ Torr (12.0 × 10⁻⁴ Pa) or less. The deposition rate is not limited, as long as it is not detrimental to the advantages of the present invention, and is typically 0.1 Å/second or more, typically 5.0 Å/second or less. The deposition temperature in the vapor deposition is not limited, as long as it is not detrimental to the advantages of the present invention, and is preferably 10°C or more, preferably 50°C or less.

### Hole Transport Layer

The hole transport layer 4 may be formed on the hole injection layer 3 when the hole injection layer 3 is present, and on the anode 2 when the hole injection layer 3 is not present. The organic electroluminescent element of the present invention may be configured without the hole transport layer 4. However, as described above, the organic electroluminescent element of the present invention preferably has the hole transport layer.

The method used to form the hole transport layer 4 is not particularly limited, and may be a vacuum deposition method or a wet film forming method. However, from the standpoint of reducing dark spots, it is preferable to form the hole transport layer 4 by using a wet film forming method.

The material forming the hole transport layer 4 is preferably one that has high hole transportability, and that can efficiently transport the injected holes. It is therefore preferable that the material has small ionization potential, high transparency for visible light, large hole mobility, and excellent stability, and does not easily generate trapping impurities during production or use. Further, because the hole transport layer 4 is often in contact with the light emitting layer 5, the material preferably does not quench the emission from the light emitting layer 5, or form an exciplex between the hole transport layer 4 and the light emitting layer 5 so that there is no lowering of efficiency.

Conventional materials usable as constituent material of the hole transport layer 4 may be used as the material of the hole transport layer 4. For example, the materials exemplified above as the hole transporting compounds used for the hole injection layer 3 may be used. Examples include arylamine derivatives, fluorene derivatives, spiro derivatives, carbazole derivatives, pyridine derivatives, pyrazine derivatives, pyrimidine derivatives, triazine derivatives, quinoline derivatives, phenanthroline derivatives, phthalocyanine derivatives, porphyrin derivatives, silole derivatives, oligothiophene derivatives, condensed polycyclic aromatic derivatives, and metal complexes.

Other examples include polyvinylcarbazole derivatives, polyarylamine derivatives, polyvinyltriphenylamine derivatives, polyfluorene derivatives, polyarylene derivatives, tetraphenylbenzidine-containing polyarylene ether sulfone derivatives, polyarylenevinylene derivatives, polysiloxane derivatives, polythiophene derivatives, and poly(p-phenylenevinylene) derivatives. These may be alternate copolymers, random polymers, block polymers, or graft copolymers. Further, these may be polymers having a branched main chain with three terminal portions, or may be compounds commonly referred to as dendrimers.

Polyarylamine derivatives, and polyarylene derivatives are preferred.

Preferably, the polyarylamine derivatives are polymers having the repeating unit of the following formula (II), particularly preferably polymers formed of the repeating unit of the following formula (II). In this case, Ar^{a} and Ar^{b} in the repeating unit may be the same or different. 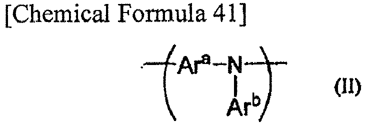 (In the formula (II), Ar^{a} and Ar^{b} each independently represent an aromatic hydrocarbon group that may have a substituent, or an aromatic heterocyclic group that may have a substituent.)

Examples of the optionally substituted aromatic hydrocarbon group represented by Ar^{a} and Ar^{b} include groups derived from a single ring or 2 to 5 fused rings of six-membered rings, such as a benzene ring, a naphthalene ring, an anthracene ring, a phenanthrene ring, a perylene ring, a tetracene ring, a pyrene ring, a benzopyrene ring, a chrysene ring, a triphenylene ring, an acenaphthene ring, a fluoranthene ring, and a fluorene ring, and groups containing two or more of these rings joined to each other via a direct bond.

Examples of the optionally substituted aromatic heterocyclic group include groups derived from a single ring or 2 to 4 fused rings of 5- or 6-membered rings, such as a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a shinorine ring, a quinoxaline ring, a phenanthridine ring, a benzoimidazole ring, a perimidine ring, a quinazoline ring, a quinazolinone ring, and an azulene ring, and groups containing two or more of these rings joined to each other via a direct bond.

For solubility and heat resistance, Ar^{a} and Ar^{b} are preferably each independently groups derived from a ring selected from a benzene ring, a naphthalene ring, an anthracene ring, a phenanthrene ring, a triphenylene ring, a pyrene ring, a thiophene ring, a pyridine ring, and a fluorene ring, or groups containing two or more benzene rings joined to each other (for example, biphenyl group (biphenyl), and terphenylene group (terphenylene)).

Particularly preferred are benzene ring-derived groups (phenyl), groups containing two benzene rings joined to each other (biphenyl), and fluorene ring-derived groups (fluorenyl).

Examples of the substituent of the aromatic hydrocarbon group and the aromatic heterocyclic group represented by Ar^{a} and Ar^{b} include alkyl, alkenyl, alkynyl, alkoxy, aryloxy, alkoxycarbonyl, dialkylamino, diarylamino, acyl, halogen atom, haloalkyl, alkylthio, arylthio, silyl, siloxy, cyano, aromatic hydrocarbon ring, and aromatic heterocyclic group.

Examples of the polyarylene derivatives include polymers in which an arylene group such as the optionally substituted aromatic hydrocarbon group or aromatic heterocyclic group exemplified for Ar^{a} and Ar^{b} in the formula (II) is contained as a repeating unit.

The polyarylene derivatives are preferably polymers having a repeating unit represented by at least one of the following formulae (V-1) and (V-2). 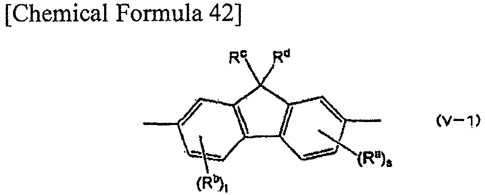 (In the formula (V-1), R^{a}, R^{b}, R^{c}, and R^{d} each independently represent alkyl, alkoxy, phenylalkyl, phenylalkoxy, phenyl, phenoxy, alkylphenyl, alkoxyphenyl, alkylcarbonyl, alkoxycarbonyl, and carboxy. t and s each independently represent an integer of 0 to 3. When t or s is 2 or more, the plurality of R^{a} or R^{b} contained in a single molecule may be the same or different, and the adjacent R^{a} or R^{b} may together form a ring.) 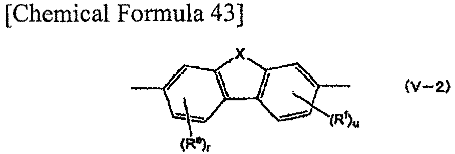 (In the formula (V-2), R^{e} and R^{f} each independently have the same meaning as R^{a}, R^{b}, R^{c}, or R^{d} in the formula (V-1). r and u each independently represent an integer of 0 to 3. When r or u is 2 or more, the plurality of R^{e} and R^{f} contained in a single molecule may be the same or different, and the adjacent R^{e} or R^{f} may together form a ring. X represents an atom or a group of atoms that forms a five-membered ring or a six-membered ring.)

Specific examples of X include -O-, -BR-, -NR-, -SiR₂-, -PR-, -SR-, -CR₂-, and groups formed by binding of these groups. R represents a hydrogen atom, or any organic group. The organic groups in the present invention are groups that contain at least one carbon atom.

The polyarylene derivatives preferably have the repeating unit of the following formula (V-3), in addition to the repeating unit represented by at least one of the formulae (V-1) and (V-2). 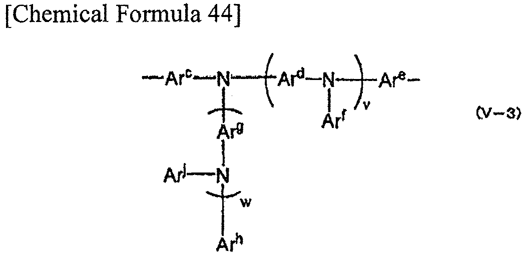 (In the formula (V-3), Ar^{c} to Ar^{j} each independently represent an aromatic hydrocarbon group that may have a substituent, or an aromatic heterocyclic group that may have a substituent. v and w each independently represent 0 or 1.)

Specific examples of Ar^{c} to Ar^{j} are the same as those exemplified for Ar^{a} and Ar^{b} in the formula (II).

Specific examples of the formulae (V-1) to (V-3), and specific examples of the polyarylene derivatives include those described in JP-A-2008-98619.

When the hole transport layer 4 is formed by using a wet film forming method, the hole transport layer forming composition is prepared first, and this is followed by wet deposition and heat drying, as with the case of the hole injection layer 3.

The hole transport layer forming composition contains a solvent, in addition to the hole transporting compound. The same solvent used for the hole injection layer forming composition is used. The deposition conditions, and heating and drying conditions are also the same as for the hole injection layer 3.

When using a vacuum deposition method to form the hole transport layer 4, the deposition and other conditions are the same as for the hole injection layer 3.

The hole transport layer 4 may contain components such as various light emitting materials, electron transporting compounds, binder resins, and coat improvers, in addition to the hole transporting compound.

The hole transport layer 4 may be a layer formed by crosslinking a crosslinking compound. The crosslinking compound is a compound having a crosslinking group, and forms a meshed polymer compound upon being crosslinked.

Examples of the crosslinking group include cyclic ether-derived groups such as oxetane, and epoxy; unsaturated double bond-derived groups such as vinyl, trifluorovinyl, styryl, acryl, methacryloyl, and cinnamoyl; and benzocyclobutene-derived groups.

The crosslinking compound may be a monomer, an oligomer, or a polymer. The crosslinking compound may be used either alone, or in any combination and proportion of two or more.

Preferably, a hole transporting compound having a crosslinking group is used as the crosslinking compound. The hole transporting compound may be one exemplified above, for example, one in which a crosslinking group is bound to the main chain or side chain of the hole transporting compound. Preferably, the crosslinking group is bound to the main chain via a linking group such as an alkylene group. The hole transporting compound is preferably a polymer that contains a repeating unit having a crosslinking group, preferably a polymer having the repeating unit of the formula (II) or formula (V-1), (V-2), or (V-3) with a crosslinking group bound thereto either directly or via a linking group.

Preferably, a hole transporting compound having a crosslinking group is used as the crosslinking compound. Examples of the hole transporting compound include nitrogen-containing aromatic compound derivatives such as pyridine derivatives, pyrazine derivatives, pyrimidine derivatives, triazine derivatives, quinoline derivatives, phenanthroline derivatives, carbazole derivatives, phthalocyanine derivatives, and porphyrin derivatives; triphenylamine derivatives; silole derivatives; oligothiophene derivatives, condensed polycyclic aromatic derivatives, and metal complexes. Preferred are nitrogen-containing aromatic derivatives such as pyridine derivatives, pyrazine derivatives, pyrimidine derivatives, triazine derivatives, quinoline derivatives, phenanthroline derivatives, and carbazole derivatives; triphenylamine derivatives, silole derivatives, condensed polycyclic aromatic derivatives, and metal complexes. Particularly preferred are triphenylamine derivatives.

The hole transport layer 4 is formed by crosslinking the crosslinking compound, typically as follows. A hole transport layer forming composition prepared by dissolving or dispersing the crosslinking compound in a solvent is deposited by wet deposition to crosslink the crosslinking compound.

The hole transport layer forming composition may contain additives that promote the crosslink reaction, in addition to the crosslinking compound. Examples of the additives that promote the crosslink reaction include polymerization initiators and polymerization promoting agents such as alkylphenone compounds, acylphosphine oxide compounds, metallocene compounds, oxime ester compounds, azo compounds, and onium salts; and photosensitizers such as condensed polycyclic hydrocarbon, porphyrin compounds, and diarylketone compounds.

The hole transport layer forming composition may also contain additives such as coat improvers (such as leveling agents, and defoaming agents), electron-accepting compounds, and binder resins.

The hole transport layer forming composition contains the crosslinking compound typically in 0.01 weight% or more, preferably 0.05 weight% or more, further preferably 0.1 weight% or more, typically 50 weight% or less, preferably 20 weight% or less, further preferably 10 weight% or less.

The hole transport layer forming composition containing the crosslinking compound in these concentration ranges is deposited on the underlayer (typically, the hole injection layer 3), and irradiated with activation energy (for example, heat and/or light) to crosslink the crosslinking compound and form the meshed polymer compound.

The temperature, humidity, and other deposition conditions are the same as those used in the wet deposition of the hole injection layer.

The technique used for the heating after the deposition is not particularly limited. Heating is performed under the temperature condition of typically 120°C or more, preferably 400°C or less.

Heating time is typically 1 minute or more, preferably 24 hours or less. The heating means is not particularly limited, and a laminate with the deposited layers may be heated on a hot plate, or in an oven. For example, heating may be performed on a hot plate at 120°C or more for at least 1 minute.

Irradiation of activation energy such as light may be performed by using methods that directly make use of ultraviolet, visible, and infrared light sources such as a ultra high-pressure mercury lamp, a high-pressure mercury lamp, a halogen lamp, and an infrared lamp, or methods that use a mask aligner and a conveyor-type photoirradiator equipped with these light sources. Irradiation of activation energy other than light may be performed, for example, by irradiating microwaves generated by a magnetron, specifically by using an irradiation method that uses a microwave. Irradiation time is preferably set to satisfy conditions required to lower the film solubility, and is typically 0.1 seconds or more, preferably 10 hours or less.

Irradiation of activation energy such as heat and light may be performed either alone or in combination. When performed in combination, the order is not particularly limited.

The hole transport layer 4 formed as above has a thickness of typically 5 nm or more, preferably 10 nm or more, and typically 300 nm or less, preferably 100 nm or less.

### Light Emitting Layer

The light emitting layer 5 is provided on the hole injection layer 3, or on the hole transport layer 4 when the hole transport layer 4 is provided. The light emitting layer 5 is a layer that serves as the main light source upon being excited by the recombination of the holes injected from the anode 2 and the electrons injected from the cathode 9 between the electrodes under applied electric field.

The light emitting layer 5 is as described in the foregoing Light Emitting Layer section.

### Hole Relaxation Layer

The organic electroluminescent element of the present invention may include a hole relaxation layer, though not illustrated in FIG. 1.

The hole relaxation layer is a layer formed adjacent to the light emitting layer on the cathode side, and serves to relax accumulation of holes at the interface between the light emitting layer and the hole relaxation layer. The hole relaxation layer also has a role of efficiently transporting electrons toward the light emitting layer.

The hole relaxation layer may be formed between the coated light emitting layer and the vapor deposited light emitting layer.

The hole relaxation layer has an ionization potential of typically 5.5 eV or more, preferably 5.6 eV or more, more preferably 5.7 eV or more, and typically 6.7 eV or less, preferably 6.4 eV or less, more preferably 6.0 eV or less. An ionization potential value above and below these ranges may cause accumulation of holes at the interface of the light emitting layer and the hole relaxation layer.

The hole relaxation layer may have any thickness, as long as it is not detrimental to the advantages of the present invention, and the thickness is preferably 0.3 nm or more, more preferably 0.5 nm or more, preferably 100 nm or less, more preferably 50 nm or less. When the thickness of the hole relaxation layer is too thin, defects may occur in the thin film. When too thick, driving voltage may increase.

The hole relaxation layer is preferably formed by using a vacuum deposition method, and the same method exemplified above as a vacuum deposition method may be used.

The electron transport layer is typically formed adjacent to the hole relaxation layer on the cathode side. The ionization potential difference between the hole relaxation layer and the electron transport layer may have any value, as long as it is not detrimental to the advantages of the present invention, and is typically less than 0.5 eV, preferably less than 0.3 eV, more preferably less than 0.2 eV. When the ionization potential difference is too large, there is a possibility of the holes accumulating in the hole relaxation layer, and causing deterioration.

In the present invention, an organic compound having a hole transporting unit and an electron transporting unit is used as the hole relaxation material of the hole relaxation layer. Here, the hole transporting unit (hole transport unit) is a structure (unit) having excellent durability against the holes, and a hole transporting property.

The electron transporting unit (electron transport unit) is a structure (unit) having excellent durability against the electrons, and an electron transporting property.

The hole mobility µH of the hole relaxation material in the present invention is typically 1 × 10⁻⁶ cm⁻²/V·s or more, preferably 1 × 10⁻⁴ cm⁻²/V·s or more, more preferably 1 × 10⁻³ cm⁻²/V·s or more as measured by using the charge mobility measurement method described below.

The upper limit of hole mobility is not particularly limited, because faster mobility further decreases the driving voltage in the product element. The upper limit is typically 1 × 10⁻¹ cm⁻²/V·s or less.

The electron mobility µE of the hole relaxation material is typically 1 × 10⁻⁶ cm⁻²/V·s or more, preferably 1 × 10⁻⁵ cm⁻²/V·s, more preferably 1 × 10⁻⁴ cm²/V·s or more as measured by the charge mobility measurement method.

The upper limit of electron mobility is not particularly limited, because faster mobility further decreases the driving voltage in the product element. The upper limit is typically 1 × 10⁻¹ cm⁻²/V·s or less.

These ranges are preferable, because the residence time of the charges in the layer decreases, and the holes and electrons do not easily deteriorate the layer.

The electron mobility and hole mobility ratio (µE/µH) of the hole relaxation material is typically 100 to 0.1, preferably 50 to 0.5, more preferably 10 to 0.5.

The ratio (µE/µH) preferably falls in these ranges, because the holes and electrons do not easily flow into other layers from the light emitting layer, and do not easily degrade the element, and thus increase the element life.

The hole relaxation material used in the present invention is an organic compound of a structure that includes one or more hole transport units and one or more electron transport units in any proportions.

The hole transport unit of the present invention is a structure (unit) having excellent durability against the holes, and a hole transporting property, specifically a hole-stable unit having an ionization potential with which holes can be easily extracted from the light emitting layer.

The ionization potential with which holes can be easily extracted from the light emitting layer is typically 5.4 to 6.3 eV, preferably 5.5 to 6.2 eV, more preferably 5.6 to 6.1 eV

"Hole-stable" means that the hole transport unit does not easily degrade even in the radical state. In other words, the hole transport unit remains stable even in the radical state because of the delocalized radical cations.

Examples of the structure of the unit having such performance include a structure with a heteroatom having sp3 orbitals, and an aromatic fused ring of 4n carbon atoms.

Specific examples include a carbazole ring, a phthalocyanine ring, a naphthalocyanine structure, a porphyrin structure, a triarylamine structure, a triarylphosphine structure, a benzofuran ring, a dibenzofuran ring, a pyrene ring, a phenylenediamine structure, a pyrrole ring, a benzidine structure, an aniline structure, a diarylamine structure, an imidazolidinone structure, and a pyrazole ring.

Of these, a carbazole ring, a benzofuran ring, a dibenzofuran ring, a pyrene ring, and a triarylamine structure are preferred. A carbazole ring, a benzofuran ring, a dibenzofuran ring, and a pyrene ring are more preferred. A carbazole ring, and a pyrene ring are particularly preferred. A carbazole ring is most preferred.

The electron transport unit of the present invention is a structure (unit) having excellent durability against the electrons, and an electron transporting property, specifically a unit that allows for easy entry of electrons, and that easily stabilizes the entered electrons. For example, a pyridine ring is slightly electron deficient because of the nitrogen atom, and is likely to accept electrons. The entered electrons in the ring are delocalized, and stabilize on the pyridine ring.

Examples of the structure of the unit having such performance include a monocyclic or a fused ring that contains a heteroatom having sp2 hybrid orbitals.

Specific examples include a quinoline ring, a quinazoline ring, a quinoxaline ring, a phenanthroline ring, a pyridine ring, a pyrimidine ring, a pyridazine ring, a pyrazine ring, a triazine ring, a thiadiazole ring, a benzothiadiazole ring, a quinolinol metal complex, a phenanthroline metal complex, a hexaazatriphenylene structure, and a tetrasialbenzoquinoline structure.

Preferred examples include a quinoline ring, a quinazoline ring, a quinoxaline ring, a phenanthroline ring, a pyridine ring, a pyrimidine ring, a pyridazine ring, a pyrazine ring, and a triazine ring. Particularly preferred are a quinoline ring, a quinazoline ring, a pyridine ring, a pyrimidine ring, a triazine ring, and a 1,10-phenanthroline ring for their excellent electrical stability.

When the electron transport unit is a single ring or fused rings of six-membered rings containing a nitrogen atom, it is preferable that the positions ortho and para to the nitrogen atom are all substituted with an aromatic ring.

This is because the o- and p-positions of a nitrogen atom-containing six-membered ring are active sites, and the substitution with an aromatic ring group delocalizes the electrons, and provides electron stability.

That is, the hole relaxation material of the present invention has excellent durability against electrical oxidation and reduction.

When the electron transport unit is a fused ring, the positions ortho and para to the nitrogen atom, and not forming a part of the fused ring may be substituted with an aromatic ring group.

The hole relaxation material is preferably an organic compound having a combination of a derivative of the rings given in the following group (a) (hole transport unit) and a derivative of the rings given in the following group (b) (electron transport unit). 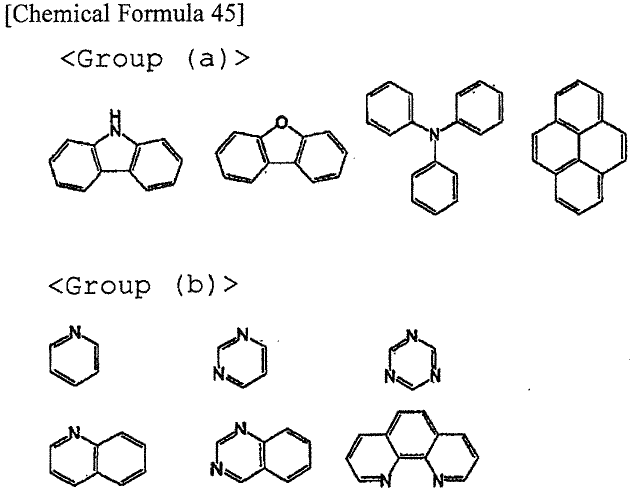 (The rings in group (b) are all substituted with an aromatic ring at the o- and p-positions to the nitrogen atom.)

In group (b), the aromatic ring groups replacing the hydrogen atoms at positions 2, 4, and 6 to the nitrogen atom of the same ring are not particularly limited, and may be aromatic hydrocarbon groups or aromatic heterocyclic groups. However, the aromatic ring groups are preferably aromatic hydrocarbon groups for their excellent durability against electrical oxidation.

Examples of the hole relaxation material include compounds having the structure represented by the following general formula (1). 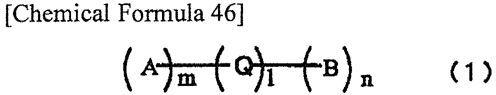 (In the general formula (1), A each independently represents a hole transport unit of 1 to 30 carbon atoms, B each independently represents an electron transport unit of 1 to 30 carbon atoms, Q represents alkylene of 1 to 10 carbon atoms, alkenylene of 2 to 10 carbon atoms, or a bivalent aromatic hydrocarbon group of 6 to 30 carbon atoms, and these may be further substituted. n and m represent an integer of 1 to 4, and 1 represents an integer of 0 to 3. In the general formula (1), when 1, m, and n are 2 or more, the plurality of Q, A, or B may be the same or different.)

Examples of the hole transport unit A and the electron transport unit B include those exemplified above. Specific examples and preferred forms are also as described above.

In the formula (1), Q represents alkylene of 1 to 10 carbon atoms, alkenylene of 2 to 10 carbon atoms, or a bivalent aromatic hydrocarbon group of 6 to 30 carbon atoms.

The alkylene of 1 to 10 carbon atoms is preferably alkylene of 1 to 8 carbon atoms. Specific examples include methylene, 1,2-ethylene, 1,3-propylene, 1,4-butylene, 1,5-pentylene, and 1,8-octylene. Methylene, and 1,2-ethylene are preferred for ease of synthesis.

The alkenylene of 2 to 10 carbon atoms is preferably alkenylene of 2 to 6 carbon atoms. Specific examples include 1,2-vinylene, 1,3-propenylene, 1,2-propenylene, and 1,4-butenylene. Vinylene is preferred, because it improves the flatness of the molecules and widens the conjugate plane, and further delocalizes the charges and improves the compound stability.

Examples of the bivalent aromatic hydrocarbon group of 6 to 30 carbon atoms include a single ring or 2 to 5 fused rings, and bivalent groups formed by more than one of these rings joined to each other. Here, "more than one" typically means 2 to 8, preferably 2 to 5 from the standpoint of ring stability.

Specific examples of the bivalent aromatic hydrocarbon group include bivalent aromatic hydrocarbon groups derived from a benzene ring, a naphthalene ring, a phenanthrene ring, an anthracene ring, a triphenylene ring, a chrysene ring, a naphthacene ring, a perylene ring, and a coronene ring. Preferred for ring stability are bivalent groups derived from a benzene ring, a naphthalene ring, an anthracene ring, and a triphenylene ring.

The molecular weight of the hole relaxation material is typically 10,000 or less, preferably 5,000 or less, more preferably 4,000 or less, further preferably 3,000 or less, and typically 100 or more, preferably 200 or more, more preferably 300 or more, further preferably 400 or more.

### Hole Blocking Layer

The hole blocking layer 6 may be provided between the light emitting layer 5 and the electron injection layer 8 (described later). The hole blocking layer 6 is a layer laminated on the light emitting layer 5 in contact therewith at the interface of the light emitting layer 5 on the cathode 9 side. The hole blocking layer 6 may thus be provided in place of the hole relaxation layer.

The hole blocking layer 6 has a role to prevent the incoming holes from the anode 2 from reaching the cathode 9, and a role of efficiently transporting the injected electrons from the cathode 9 toward the light emitting layer 5.

Some of the physical properties required of the material forming the hole blocking layer 6 are high electron mobility and low hole mobility, large energy gap (the difference between HOMO and LUMO), and high excited triplet level (T1). Examples of the material of the hole blocking layer 6 satisfying such conditions include mixed ligand complexes such as bis(2-methyl-8-quilinolato)(phenolato)aluminum, and bis(2-methyl-8-quilinolato)(triphenylsilanolato)aluminum; metal complexes such as a bis(2-methyl-8-quinolato)aluminum-µ-oxo-bis-(2-methyl-8-quinolilato)aluminum binuclear metal complex; styryl compounds such as distyrylbiphenyl derivatives (JP-A-11-242996); triazole derivatives such as 3-(4-biphenylyl)-4-phenyl-5(4-tert-butylphenyl)-1,2,4-triazole (JP-A-7-41759); and phenanthroline derivatives such as bathocuproin (JP-A-10-79297). Also preferred as the material of the hole blocking layer 6 is the compound having at least one pyridine ring substituted at the 2, 4, and 6 position (WO2005-022962).

The material of the hole blocking layer 6 may be used either alone, or in any combination and proportion of two or more.

The method used to form the hole blocking layer 6 is not limited, and may be any method, including a wet film forming method, and a vapor deposition method.

The hole blocking layer 6 may have any thickness, as long as it is not detrimental to the advantages of the present invention. The thickness of the hole blocking layer 6 is typically 0.3 nm or more, preferably 0.5 nm or more, and typically 100 nm or less, preferably 50 nm or less.

### Electron Transport Layer

The electron transport layer 7 may be provided between the light emitting layer 5 and the electron injection layer 8 (described later).

The electron transport layer 7 is provided to further improve the luminescence efficiency of the element, and is formed of a compound that can efficiently transport the injected electrons from the cathode 9 toward the light emitting layer 5 between the electrodes under applied electric field.

The electron transporting compound used for the electron transport layer 7 is typically a compound having high injection efficiency for the electrons from the cathode 9 or the electron injection layer 8, and high electron mobility, capable of efficiently transporting the injected electrons. Examples of the compounds satisfying such conditions include metal complexes (such as an aluminum complex of 8-hydroxyquinoline) (JP-A-59-194393), metal complexes of 10-hydroxybenzo[h]quinoline, oxadiazole derivatives, distyrylbiphenyl derivatives, silole derivatives, 3-hydroxyflavone metal complexes, 5-hydroxyflavone metal complexes, benzoxazole metal complexes, benzothiazole metal complexes, trisbenzimidazolylbenzene (US Patent 5645948), quinoxaline compounds (JP-A-6-207169), phenanthroline derivatives (JP-A-5-331459), 2-t-butyl-9,10-N,N'-dicyanoanthraquinone diimine, n-type hydrogenated amorphous silicon carbide, n-type zinc sulfide, and n-type zinc selenide.

The material of the electron transport layer 7 may be used either alone, or in any combination and proportion of two or more.

The method used to form the electron transport layer 7 is not limited, and may be any method, including a wet film forming method, and a vapor deposition method.

The electron transport layer 7 may have any thickness, as long as it is not detrimental to the advantages of the present invention. The thickness of the electron transport layer 7 is typically 1 nm or more, preferably 5 nm or more, and typically 300 nm or less, preferably 100 nm or less.

### Electron Injection Layer

The electron injection layer 8 has a role of efficiently injecting the injected electrons from the cathode 9 to the light emitting layer 5. For efficient electron injection, metals having small work functions are preferably used as the material of the electron injection layer 8. For example, alkali metals such as sodium and cesium, and alkali earth metals such as barium and calcium are used. Typically, the thickness is preferably 0.1 nm or more, and 5 nm or less.

Organic electron transport compounds as represented by nitrogen-containing heterocyclic compounds such as bathophenanthroline, and metal complexes such as an 8-hydroxyquinoline aluminum complex may be doped with an alkali metal such as sodium, potassium, cesium, lithium, and rubidium (described in JP-A-10-270171, JP-A-2002-100478, JP-A-2002-100482, and elsewhere). This is preferable, because it can improve electron injectability and transportability while providing excellent film quality at the same time. In this case, the thickness is typically 5 nm or more, preferably 10 nm or more, and typically 200 nm or less, preferably 100 nm or less.

The material of the electron injection layer 8 may be used either alone, or in any combination and proportion of two or more.

The method used to form the electron injection layer 8 is not limited, and may be any method, including a wet film forming method, and a vapor deposition method.

### Cathode

The cathode 9 has a role of injecting electrons to the layers (such as the electron injection layer 8, and the light emitting layer 5) on the side of the light emitting layer 5.

The same materials used for the anode 2 may be used for the cathode 9. However, for efficient electron injection, metals having small work functions, for example, such as suitable metals (e.g., tin, magnesium, indium, calcium, aluminum, and silver), and alloys thereof are preferably used. Specific examples include small-work-function alloy electrodes such as a magnesium-silver alloy, a magnesium-indium alloy, and an aluminum-lithium alloy.

The material of the cathode 9 may be used either alone, or in any combination and proportion of two or more.

The cathode 9 typically may have the same thickness as the anode 2.

For the protection of the cathode 9 formed of small-work-function metal, it is preferable to laminate an atmosphere-stable metal layer having a large work function, because it makes the element more stable. For this purpose, metals, for example, such as aluminum, silver, copper, nickel, chromium, gold, and platinum are used. These materials may be used either alone, or in any combination and proportion of two or more.

### Other Layers

The organic electroluminescent element according to the present invention may have other configurations, provided that such changes do not depart from the gist of the present invention. For example, any layer different from the layers described above may be provided between the anode 2 and the cathode 9, or any of the layers may be omitted, provided that the performance is maintained.

An example of such an additional layer is an electron blocking layer.

The electron blocking layer is provided between the hole injection layer 3 or the hole transport layer 4 and the light emitting layer 5, and prevents the incoming electrons from the light emitting layer 5 from reaching the hole injection layer 3 to increase the probability of hole and electron recombination in the light emitting layer 5, and confine the generated excitons in the light emitting layer 5. Another role of the electron blocking layer is to efficiently transport the injected holes from the hole injection layer 3 toward the light emitting layer 5. It is particularly effective to provide the electron blocking layer when a phosphorescent-light emitting material is used as the light emitting material, or when blue emitting material is used.

Some of the properties required of the electron blocking layer include high hole transportability, large energy gap (the difference between HOMO and LUMO), and high excited triplet level (T1). In the present invention, the electron blocking layer needs to have compatibility to wet deposition when the light emitting layer 5 is produced as the organic layer of the present invention by using a wet film forming method. Examples of such materials of the electron blocking layer include the dioctylfluorene and triphenylamine copolymer as represented by F8-TFB (WO2004/084260).

The material of the electron blocking layer may be used either alone, or in any combination and proportion of two or more.

The method used to form the electron blocking layer is not limited, and may be any method, including a wet film forming method, and a vapor deposition method.

The element efficiency can be effectively improved by inserting an ultra-thin insulating film (0.1 to 5 nm) formed by using, for example, lithium fluoride (LiF), magnesium fluoride (MgF₂), lithium oxide (Li₂O), and cesium(II) carbonate (CsCO₃) at the interface between the cathode 9 and the light emitting layer 5 or the electron transport layer 7 (see, for example, Applied Physics Letters, 1997, Vol. 70, pp. 152; JP-A-10-74586; IEEE Transactions on Electron Devices, 1997, Vol. 44, pp. 1245; SID 04 Digest, pp. 154).

In the layer configuration described above, the constituting elements, except for the substrate, may be laminated in the reversed order. For example, referring to the layer configuration shown in FIG. 1, the cathode 9, the electron injection layer 8, the electron transport layer 7, the hole blocking layer 6 or the hole relaxation layer, the light emitting layer 5, the hole transport layer 4, the hole injection layer 3, and the anode 2 may be formed on the substrate 1 in this order.

Further, the organic electroluminescent element according to the present invention may be formed by laminating the constituting elements other than the substrate between a pair of substrates at least one of which is transparent.

It is also possible to have a structure in which the constituting elements (emission units) other than the substrate are laminated in multiple stages (a structure with laminated emission units). In this case, it is preferable to provide a carrier generation layer (CGL) of, for example, vanadium pentoxide (V₂O₅) instead of the interface layers (ITO and Al when these are used for anode and cathode, respectively) between the different stages (between the emission units), because it creates fewer barriers between the stages, and improves luminescence efficiency and driving voltage.

Further, the organic electroluminescent element according to the present invention may be configured as a single organic electroluminescent element, or may be applied to a configuration in which a plurality of organic electroluminescent elements is disposed in an array, or a configuration in which the anode and the cathode are disposed in an X-Y matrix.

The layers described above may contain components other than the materials described above, provided that such addition is not detrimental to the advantages of the present invention.

### Organic EL Display Device

The organic EL display device of the present invention uses the organic electroluminescent element of the present invention. The type and structure of the organic EL display device of the present invention are not particularly limited, and the organic EL display device may be assembled according to an ordinary method with the organic electroluminescent element of the present invention.

For example, the organic EL display device of the present invention may be formed by using the method described in Organic EL Display (Ohm, published August 20, 2004, Shizuo Tokito, Chihaya Adachi, Hideyuki Murata).

### Organic EL Lighting

The organic EL lighting of the present invention uses the organic electroluminescent element of the present invention. The type and structure of the organic EL lighting of the present invention are not particularly limited, and the organic EL lighting may be formed according to an ordinary method with the organic electroluminescent element of the present invention.

### Examples

The present invention is described below in greater detail using Examples. It should be noted, however, that the present invention is not limited to the descriptions of the following Examples, as long as the contents of the invention do not depart from the gist of the present invention.

The maximum emission wavelengths of the light emitting materials used in the following Examples and Comparative Examples were determined by measuring the emission spectrum with a spectrophotometer F4500 (Hitachi), using an about 1.0 × 10⁻⁵ M to 1.0 × 10⁻⁶ M toluene (methylene chloride when the material was poorly soluble) solution prepared for each material. Table 1 below presents the maximum emission wavelength of each light emitting material. [Table 1]

**Table 1**

| Light emitting material | Maximum emission wavelength (nm) |
|---|---|
| GD-1 | 515 |
| GD-2 | 518 |
| RD-1 | 616 |
| RD-2 | 596 |
| RD-3 | 629 |
| BD-1 | 461 |
| BD-2 | 456 |
| BD-3 | 459 |

### Example 1

An organic electroluminescent element of the configuration shown in FIG. 1 was produced with the omission of the hole blocking layer 6.

### Anode

The anode 2 was formed on a glass substrate by patterning a deposited indium tin oxide (ITO) transparent conductive film (thickness 150 nm; deposited by sputtering; sheet resistance 15 Ω) into 2 mm-wide stripe patterns by using a common photolithography technique. The substrate 1 with the anode 2 was then subjected to series of treatments, starting with ultrasonic washing with acetone, water washing with deionized water, and ultrasonic washing with isopropyl alcohol, and drying by nitrogen blowing, and finally UV ozone washing.

### Hole Injection Layer

The hole injection layer 3 was formed by using a wet film forming method, as follows.

A composition containing 2 weight% of a hole transporting polymer compound having the repeating structure of the formula (PI) below, and 0.8 weight% of 4-isopropyl-4'-methyldiphenyl iodonium tetrakis(pentafluorophenyl)borate (oxidizing agent) was prepared as a hole injection layer forming composition by dissolving these components in ethyl benzoate. The composition was then deposited on the ITO substrate by spin coating.

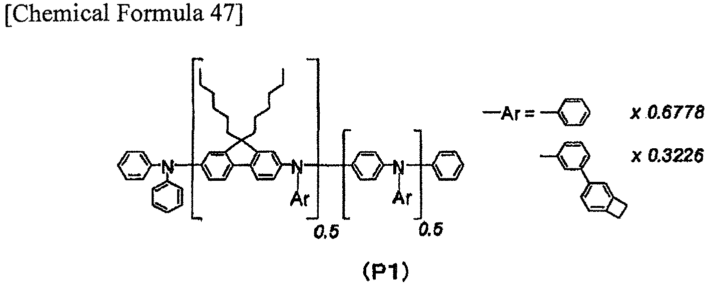

Spin coating was performed in two steps at a spinner rotation speed of 500 rpm for 2 seconds, and then 1,500 rpm for 30 seconds. The composition was dried by being heated in a 230°C clean oven for 1 hour. The resulting hole injection layer 3 had a thickness of 40 nm.

### Hole Transport Layer

The hole transport layer 4 was formed on the hole injection layer 3, as follows. A hole transport layer forming composition containing a polymer compound (HT-1) having the repeating structure below (weight average molecular weight: 45,000), and cyclohexylbenzene (solvent) was prepared as a crosslinking compound. The concentration of the polymer compound (HT-1) in the hole transport layer forming composition was 1.0 weight%.

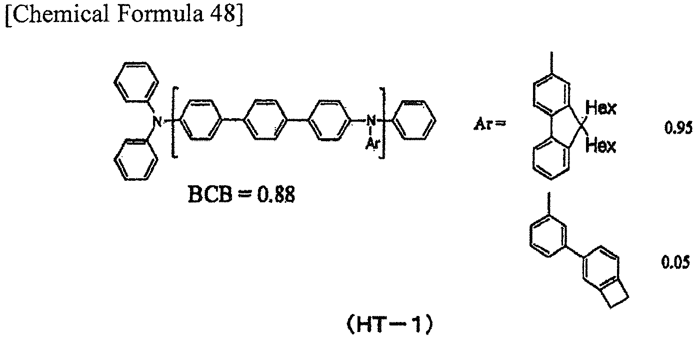

The hole transport layer forming composition was spin coated on the hole injection layer 3 in two steps at a spinner rotation speed of 500 rpm for 2 seconds, and then 1,500 rpm for 120 seconds. This was followed by heating at 230°C for 60 minutes to crosslink and cure the polymer compound (HT-1).

After these procedures, the hole transport layer 4 was obtained as a uniform thin film having a thickness of 10 nm.

### Coated Light Emitting Layer

The coated light emitting layer was formed on the hole transport layer 4, as follows.

The compounds (GH-1), (GH-2), (GD-1), and (RD-1) below were mixed at a 25:75:10:0.7 weight ratio, and a composition dissolving 1.7 weight% of the mixture in cyclohexylbenzene was prepared. The composition was then deposited on the hole transport layer 4 by spin coating in a nitrogen atmosphere.

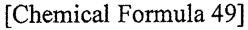

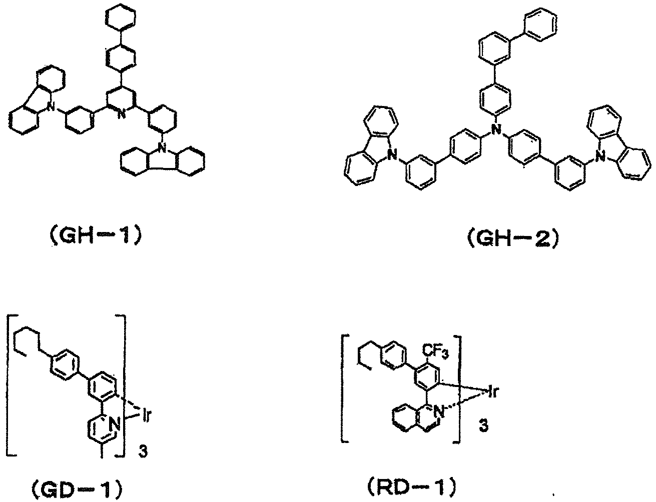

Spin coating was performed in two-steps at a spinner rotation speed of 500 rpm for 2 seconds, and 1,500 rpm for 120 seconds. This was followed by drying at 130°C for 1 hour to form a coated light emitting layer having a thickness of 20 nm.

The compound (GD-1) is a green phosphorescent-light emitting material having a maximum emission wavelength at 515 nm. The compound (RD-1) is a red phosphorescent-light emitting material having a maximum emission wavelength at 616 nm.

### Vapor Deposited Light Emitting Layer

The vapor deposited light emitting layer was formed on the coated light emitting layer by using a vacuum deposition method.

The compounds (BH-1) and (BD-1) below were vapor deposited at a 100:5 weight ratio by using a vacuum deposition method to form a vapor deposited light emitting layer having a thickness of 30 nm.

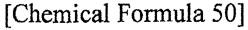

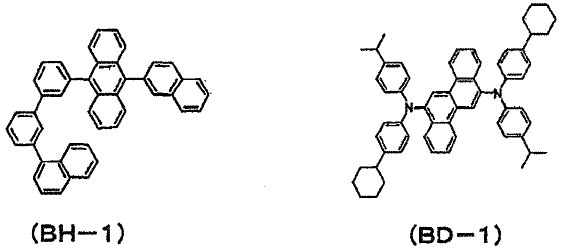

The compound (BD-1) is a blue fluorescent-light emitting material having a maximum emission wavelength at 461 nm.

### Electron Transport Layer

The compound (ET-1) below was formed as the electron transport layer 7 on the vapor deposited light emitting layer in a thickness of 20 nm by using a vacuum deposition method.

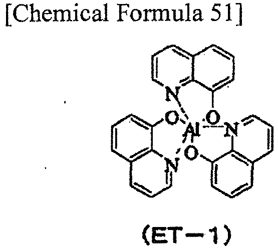

### Electron Injection Layer and Cathode

The element after the vapor deposition of the electron transport layer 7 was taken out of the vacuum vapor deposition apparatus into the atmosphere. Then, a stripe shadow mask measuring 2 mm in width and shaped to orthogonally cross the ITO stripes of the anode 2 was attached to the element as a cathode vapor deposition mask, and the element was installed in a separate vacuum vapor deposition apparatus. Lithium fluoride (LiF) and aluminum were then laminated as the electron injection layer 8 (0.5 nm thick) and the cathode 9 (80.0 nm thick), respectively, using the same vacuum deposition method used for the electron transport layer 7.

### Sealing

In order to prevent the element from being deteriorated by the moisture or other atmosphere conditions during storage, sealing was performed according to the following method.

A light-curable resin, about 1 mm wide, was applied to the periphery of a 23 mm × 23 mm glass plate in a nitrogen glove box connected to the vacuum vapor deposition apparatus, and a moisture getter sheet was placed at the central portion of the glass plate. The substrate with the finished cathode was then attached to the plate with the vapor deposited surface facing the desiccant sheet. Thereafter, only the light-curable resin applied regions were irradiated with ultraviolet rays to cure the resin. As a result, an organic electroluminescent element having a 2 mm × 2 mm emission area was obtained.

### Comparative Example 1

An element was produced in the same manner as in Example 1, except that the light emitting layer was replaced with two layers of only the vapor deposited light emitting layers, as follows.

Because the vapor deposition device did not allow for deposition beyond ternary vapor deposition, the compounds (GH-2), (GD-1), and (RD-1) were vapor deposited as light emitting layer material at a 100:10:0.7 weight ratio by using a vacuum deposition method to form a vapor deposited light emitting layer on the hole transport layer 4 in a thickness of 40 nm.

Then, the compounds (BH-1) and (BD-1) were vapor deposited at a 100:5 weight ratio by using a vacuum deposition method to laminate a vapor deposited light emitting layer in a thickness of 20 nm.

### Example 2

An organic electroluminescent element was produced in the same manner as in Example 1, except that the compounds (GH-3) and (GH-4) below and the compounds (GD-1) and (RD-1) were used at a mixture ratio of (GH-3):(GH-4):(GD-1):(RD-1) = 25:75:7:1.5 (weight ratio) in place of the materials used to form the coated light emitting layer in Example 1.

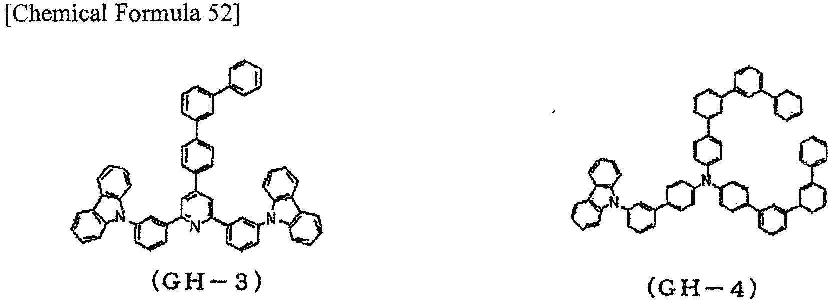

### Example 3

An organic electroluminescent element was produced in the same manner as in Example 1, except that the compound (GH-5) below, the compounds (GH-4) and (GD-1), and the compound (RD-2) below were used at a mixture ratio of (GH-5):(GH-4):(GD-1):(RD-2) = 25:75:10:1 (weight ratio) instead of using the materials used to form the coated light emitting layer in Example 1, and that 2.5 weight% of the mixture was dissolved in cyclohexylbenzene to prepare a composition, and the composition was spin coated on the hole transport layer in a nitrogen atmosphere to form a coated light emitting layer having a thickness of 30 nm.

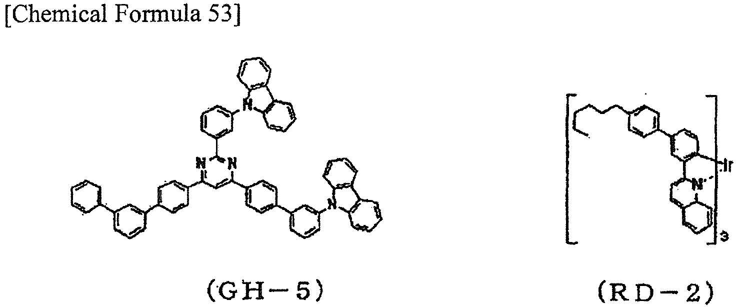

The compound (RD-2) is a red phosphorescent-light emitting material having a maximum emission wavelength at 596 nm.

### Example 4

An organic electroluminescent element was produced in the same manner as in Example 2, except that the compound (BD-2) below was used in place of the compound (BD-1) of the light emitting material used in the vapor deposited light emitting layer of Example 2.

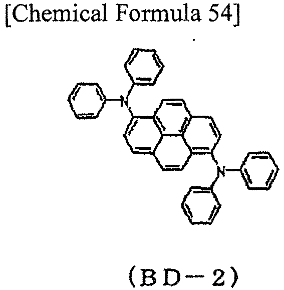

The compound (BD-2) is a blue fluorescent-light emitting material having a maximum emission wavelength at 456 nm.

### Example 5

An organic electroluminescent element was produced in the same manner as in Example 1, except that the coated light emitting layer was formed by using the compounds (GH-6), (GH-7), (GD-2), and (RD-3) at a mixture ratio of (GH-6):(GH-7):(GD-2):(RD-3) = 25:75:10:0.7 (weight ratio) instead of the coated light emitting layer materials used in Example 1, and that compound (GH-1) was used to form a 5 nm-thick hole relaxation layer on the vapor deposited light emitting layer by using a vacuum deposition method after forming the vapor deposited light emitting layer in the same manner as in Example 1.

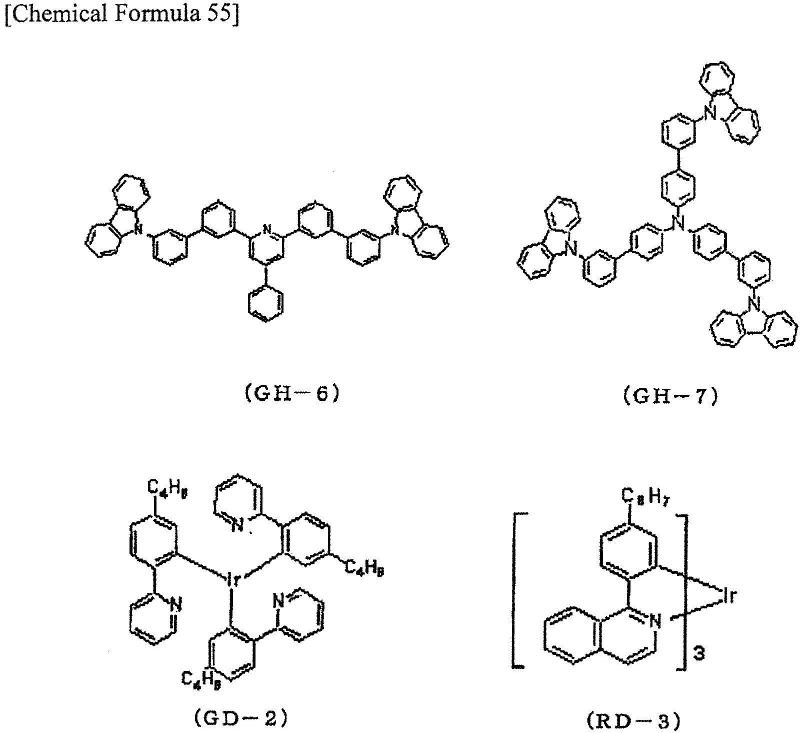

The compound (GD-2) is a green phosphorescent-light emitting material having a maximum emission wavelength at 518 nm. The compound (RD-3) is a red phosphorescent-light emitting material having a maximum emission wavelength at 629 nm.

### Example 6

An organic electroluminescent element was produced in the same manner as in Example 1, except that the polymer compound (HT-1) used to form the hole transport layer in Example 1 was changed to a polymer compound (HT-2) of the repeating structure below (weight average molecular weight: 68,000), and that the vapor deposited light emitting layer was formed by using the compound (BH-2) below instead of the compound (BH-1) used for the vapor deposited light emitting layer in Example 1, and that the hole relaxation layer was formed in a thickness of 10 nm on the vapor deposited light emitting layer using the compound (GH-1) by using a vacuum deposition method.

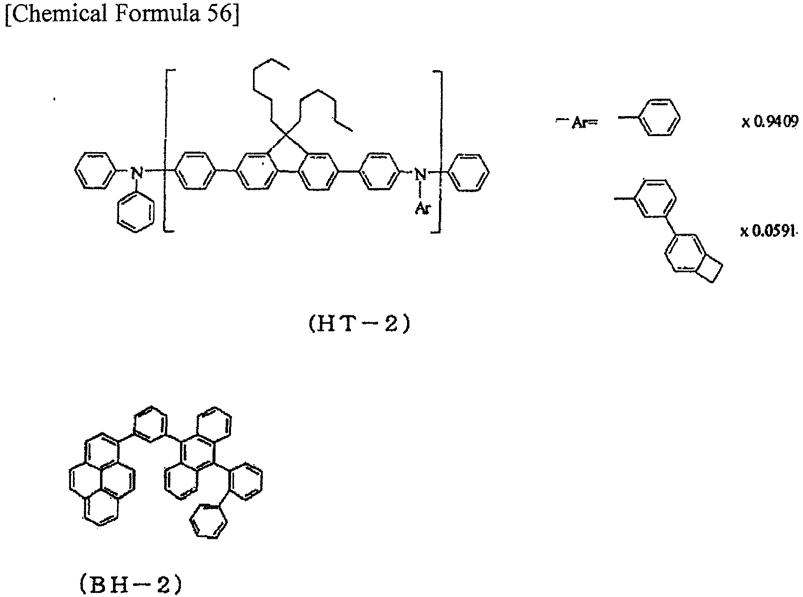

### Example 7

An organic electroluminescent element was produced in the same manner as in Example 2, except that a 5 nm-thick interlayer was formed on the coated light emitting layer using the compound (BH-2) by using a vacuum deposition method.

### Comparative Example 2

An organic electroluminescent element was produced in the same manner as in Example 1, except that the compounds (BH-3) and (BD-3) below were deposited by using a vacuum deposition method at a (BH-3):(BD-3) weight ratio of 100:5, instead of using the materials used to form the vapor deposited light emitting layer in Example 1.

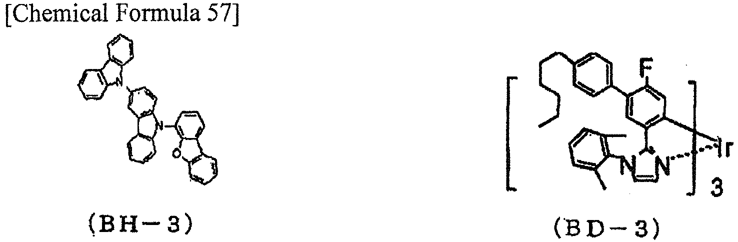

The compound (BD-3) is a blue phosphorescent-light emitting material having a maximum emission wavelength at 459 nm.

### Comparative Example 3

An element was produced in the same manner as in Comparative Example 2, except that the hole transport layer was not formed, and that the coated light emitting layer was directly laminated on the hole injection layer.

### Comparative Example 4

An organic electroluminescent element was produced in the same manner as in Example 1, except that a composition prepared by mixing polyvinyl carbazole (PVK; weight average molecular weight: 440,000) and the compounds (GD-1) and (RD-1) at a PVK:(GD-1):(RD-1) weight ratio of 100:10:0.7 and dissolving the mixture in a 1:1 mixed solvent of toluene and anisole (volume ratio) at a concentration of 0.35 weight% was used instead of the materials used to form the coated light emitting layer in Example 1. PVK is a high molecular charge-transporting material.

### Example 8

An organic electroluminescent element was produced in the same manner as in Example 1, except that a composition prepared by mixing the compounds (GH-2), (GD-1), and (RD-1) at a (GH-2):(GD-1):(RD-1) weight ratio of 100:10:0.7 and dissolving 3.3 weight% of the mixture in cyclohexylbenzene was used instead of the materials used to form the coated light emitting layer in Example 1, and that the composition was deposited on the hole transport layer by spin coating in a nitrogen atmosphere to form a 40 nm-thick coated light emitting layer. The vapor deposited light emitting layer had a thickness of 20 nm.

### Element Evaluation

The emission spectra of the elements obtained in Examples 1 to 8 and Comparative Examples 1 to 4 were measured for maximum emission wavelengths, using a spectroscope USB4000 (Ocean Optics). The elements were also measured for CIE chromaticity under applied driving voltage of 8 V. The results are presented in Tables 2 and 3.

The elements obtained in Examples 1 to 8 and Comparative Examples 1 to 4 were each measured for driving voltage and power luminescence efficiency by passing a current of 10 mA/cm² current density. As a durability evaluation, the elements were also measured for luminance relative to the initial luminance after 32 seconds of passing a current of 250 mA/cm² current density. The results are presented in Tables 2 and 3.

[Table 2]

**Table 2**

| | Configuration of light emitting layer | | | | | | @10 mA/cm² | | Relative luminance 32 seconds after passing 250 mA/cm² current | Maximum emission wavelength λ max (nm) | | | Chromaticity coordinates at 8 V |
|---|---|---|---|---|---|---|---|---|---|---|---|---|---|
| | First layer (lower layer) | | | Second layer (upper layer) | | | Driving voltage M | Power luminescence efficiency [Im/W] | | 440-500 nm (Blue) | 510-550 nm (Green) | 580 - 630 nm (Red) | |
| | Type | Material | Thickness (nm) | Type | Material | Thickness (nm) | | | | | | | |
| Ex.1 | Coated light emitting layer | (GH-1) | 20 | Vapor deposited light emitting layer | | 30 | 7.7 | 4.2 | 0.96 | 466 | 520 | 612 | (0.35, 0.36) |
| | | (GH-2) | | | (BH-1) | | | | | | | | |
| | | (GD-1) | | | (BD-1) | | | | | | | | |
| | | (RD-1) | | | | | | | | | | | |
| Ex. 2 | Coated light emitting layer | (GH-3) | 20 | Vapor deposited light emitting layer | | 30 | 6.6 | 2.7 | 0.96 | 464 | 518 | 614 | (0.33, 0.32) |
| | | (GH-4) | | | (BH-1) | | | | | | | | |
| | | (GD-1) | | | (BD-1) | | | | | | | | |
| | | (RD-1) | | | | | | | | | | | |
| Ex. 3 | Coated light emitting layer | (GH-5) | 30 | Vapor deposited light emitting layer | | 30 | 7.5 | 7.1 | 0.96 | 464 | 520 | 584 | (0.41, 0.42) |
| | | (GH-4) | | | (BH-1) | | | | | | | | |
| | | (GD-1) | | | (BD-1) | | | | | | | | |
| | | (RD-2) | | | | | | | | | | | |
| Ex. 4 | Coated light emitting layer | (GH-3) | 20 | Vapor deposited light emitting layer | | 30 | 6.8 | 2.9 | 0.96 | 464 | 518 | 614 | (0.34, 0.34) |
| | | (GH-4) | | | (BH-1) | | | | | | | | |
| | | (GD-1) | | | (BD-2) | | | | | | | | |
| | | (RD-1) | | | | | | | | | | | |
| Ex. 5 | Coated light emitting layer | (GH-6) | 20 | Vapor deposited light emitting layer | | 30 | 7.5 | 4.6 | 0.95 | 462 | 512 | 622 | (0.40, 0.39) |
| | | (GH-7) | | | (BH-1) | | | | | | | | |
| | | (GD-2) | | | (BD-1) | | | | | | | | |
| | | (RD-3) | | | | | | | | | | | |
| Ex. 6 | Coated light emitting layer | (GH-1) | 20 | Vapor deposited light emitting layer | | 30 | 8.5 | 4.4 | 0.96 | 468 | 518 | 612 | (0.33, 0.39) |
| | | (GH-2) | | | (BH-2) | | | | | | | | |
| | | (GD-1) | | | (BD-1) | | | | | | | | |
| | | (RD-1) | | | | | | | | | | | |
| Ex. 7 | Coated light emitting layer | (GH-3) | 20 | Vapor deposited light emitting layer | | 30 | 7.0 | 2.5 | 0.95 | 462 | 516 | 612 | (0.28, 0.30) |
| | | (GH-4) | | | (BH-1) | | | | | | | | |
| | | (GD-1) | | | (BH-1) | | | | | | | | |
| | | (RD-1) | | | | | | | | | | | |

[Table 3]

**Table 3**

| | Configuration of light emitting layer | | | | | | @10 mA/cm² | | Relative luminance 32 seconds after passing 250 mA/cm² current | Maximum emission wavelength λ max (nm) | | | Chromaticity coordinates at 8 V |
|---|---|---|---|---|---|---|---|---|---|---|---|---|---|
| | First layer (lower layer) | | | Second layer (upper layer) | | | Driving voltage [V] | Power luminescence efficiency [cd/A] | | 440-500 nm (Blue) | 510-550 nm (Green) | 580 - 630 nm (Red) | |
| | Type | Material | Thickness (nm) | Type | Material | Thickness (nm) | | | | | | | |
| Com. Ex.1 | Vapor deposited light emitting layer | (GH-2) | 40 | Vapor deposited light emitting layer | | 20 | 9.9 | 2.5 | 0.97 | 462 | 516 | 612 | (0.45, 0.32) |
| | | (GD-1) | | | (BH-1) | | | | | | | | |
| | | (RD-1) | | | (BD-1) | | | | | | | | |
| Com. Ex. 2 | Coated light emitting layer | (GH-1) | 20 | Vapor deposited light emitting layer | | 30 | 9.6 | 3.9 | 0.91 | 462 | 512 | 612 | (0.33, 0.34) |
| | | (GH-2) | | | (BH-3) | | | | | | | | |
| | | (GD-1) | | | (BD-3) | | | | | | | | |
| | | (RD-1) | | | | | | | | | | | |
| Com. Ex. 3 | Coated light emitting layer | (GH-1) | 20 | Vapor deposited light emitting layer | | 30 | 9.7 | 2.6 | 0.92 | 462 | 514 | 612 | (0.32, 0.36) |
| | | (GH-2) | | | (BH-3) | | | | | | | | |
| | | (GD-1) | | | (BD-3) | | | | | | | | |
| | | (RD-1) | | | | | | | | | | | |
| Com. Ex. 4 | Coated light emitting layer | PVK | 20 | Vapor deposited light emitting layer | | 30 | 10.9 | 1.7 | 0.90 | 466 | 518 | 612 | (0.33, 0.32) |
| | | (GD-1) | | | (BH-1) | | | | | | | | |
| | | (RD-1) | | | (BD-1) | | | | | | | | |
| Ex. 8 | Coated light emitting layer | (GH-2) | 40 | Vapor deposited light emitting layer | | 20 | 8.8 | 2.8 | 0.97 | 462 | 518 | 614 | (0.41, 0.31) |
| | | (GD-1) | | | (BH-1) | | | | | | | | |
| | | (RD-1) | | | (BD-1) | | | | | | | | |

It can be seen from these results that the organic electroluminescent elements of the present invention efficiently emit white light at low voltage, and have high durability.

The embodiments and concrete examples of implementation discussed in the foregoing detailed explanation serve solely to illustrate the details of the present invention, which may be applied in many variations or modifications within the spirit of the present invention as would be obvious to one skilled in the art. The present application is based on Japanese Patent Application No. 2012-007131 filed January 17, 2012, the entire contents of which are herein incorporated by reference.

### Description of Reference Numerals and Signs

1 Substrate
2 Anode
3 Hole injection layer
4 Hole transport layer
5 Light emitting layer
6 Hole blocking layer
7 Electron transport layer
8 Electron injection layer
9 Cathode
10 Organic electroluminescent element

## Claims

1. An organic electroluminescent element comprising an anode, a cathode, and a light emitting layer formed between the anode and the cathode,
wherein the light emitting layer comprises two or more layers, each of which contains a different light emitting material,
the light emitting layer includes a layer formed by a wet film forming method, and a layer formed by a vacuum deposition method, in this order from the anode side,
the layer formed by a wet film forming method is a layer containing a phosphorescent-light emitting material and a charge transport material, both of which are a low molecular compound,
the layer formed by a vacuum deposition method is a layer containing a fluorescent-light emitting material and a charge transport material, both of which are a low molecular compound, and
the organic electroluminescent element has an emission spectrum having a maximum emission wavelength in a 440 to 500 nm region, a 510 to 550 nm region, and a 580 to 630 nm region.

2. The organic electroluminescent element according to claim 1, wherein the layer formed by a wet film forming method is a layer having a maximum emission wavelength in at least two regions of the 440 to 500 nm region, the 510 to 550 nm region, and the 580 to 630 nm region.

3. The organic electroluminescent element according to claim 1 or 2, further comprising a hole transport layer between the anode and the light emitting layer.

4. The organic electroluminescent element according to claim 3, wherein the hole transport layer is a layer formed by a wet film forming method.

5. An organic EL lighting comprising the organic electroluminescent element according to any one of claims 1 to 4.

6. An organic EL display device comprising the organic electroluminescent element according to any one of claims 1 to 4.
